(19) Europäisches Patentamt
European Patent Office
Office européen des brevets

(11) **EP 4 280 252 A1**

(12) **EUROPEAN PATENT APPLICATION**

(43) Date of publication:
**22.11.2023 Bulletin 2023/47**

(21) Application number: **22173531.9**

(22) Date of filing: **16.05.2022**

(51) International Patent Classification (IPC):
**H01J 37/147** (2006.01)   **H01J 37/153** (2006.01)

(52) Cooperative Patent Classification (CPC):
**H01J 37/1471; H01J 37/153;** H01J 2237/0453;
H01J 2237/1501; H01J 2237/151; H01J 2237/1534

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **ASML Netherlands B.V.
5500 AH Veldhoven (NL)**

(72) Inventor: **SMORENBURG, Petrus, Wilhelmus
5500 AH Veldhoven (NL)**

(74) Representative: **ASML Netherlands B.V.
Corporate Intellectual Property
P.O. Box 324
5500 AH Veldhoven (NL)**

(54) **CHARGED PARTICLE OPTICAL DEVICE AND METHOD**

(57)    The present invention provides a charged particle optical device for projecting charged particle beams towards a sample position, arranged in a grid. The device comprises: a beam limiting aperture array and strip arrays. In the beam limiting aperture array is defined a plurality of apertures so as to generate the grid of beams. The strip arrays are positioned along beam paths. The strip arrays extend across the path of the plurality of beams to operate on the charged particles that pass along the path between strips of the respective strip array to collimate the path of the beams. The orientation of the strips in the array of two different arrays along the beam path are different. The beam limiting aperture array, the strip arrays or both are configured to mitigate a characteristic of the grid that is induced by passage of the beams through the strip arrays.

Fig. 9A

EP 4 280 252 A1

## Description

<u>FIELD</u>

The embodiments provided herein generally relate to a charged particle optical device and a method.

<u>BACKGROUND</u>

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause signal particles, e.g. electrons, to be emitted from the surface, such as secondary electrons, backscattered electrons or Auger electrons. The generated signal particles may be emitted from the material structure of the sample. By scanning the primary electron beam as the probing spot over the sample surface, signal particles can be emitted across the surface of the sample. By collecting these emitted signal particles from the sample surface, a pattern inspection tool may obtain data representing characteristics of the material structure of the surface of the sample. The data may be referred to as an image and may be rendered into an image.

There is a general need to improve features of a charged particle optical device.

<u>SUMMARY</u>

According to an embodiment of the invention, there is provided a charged particle optical device for projecting a plurality of beams of charged particles towards a sample position, the plurality of beams arranged in a grid, the device comprising: a beam limiting aperture array in which are defined a plurality of apertures positioned so as to generate the grid of the plurality of beams; a plurality of strip arrays positioned along the paths of the plurality of beams, the strip arrays extending across a path of the plurality of beams so as to operate on the charged particles that pass along the path between strips of the respective strip array to collimate the path of the passing beams, and the orientation of the strips in the array of at least two different arrays along the beam path being different, wherein the at least one of the beam limiting aperture array and the plurality of strip arrays is configured to mitigate a characteristic of the grid that is induced by passage of the plurality of beams through the plurality of strip arrays.

According to an embodiment of the invention, there is provided a method of projecting beams of charged particles towards a sample position using a beam limiting aperture array and a plurality of strip arrays, the method comprising: a) generating a grid of a plurality of beams from a diverging beam emitted by a source; b) projecting the plurality of beams along beam paths towards the sample position through the plurality of strip arrays; and c) using at least one of the beam limiting aperture array and the plurality of strip arrays, countering a characteristic of the grid induced by passage of the plurality of beams through the plurality of strip arrays.

According to an embodiment of the invention, there is provided a charged particle optical device for projecting a plurality of beams of charged particles towards a sample position, the plurality of beams arranged in a grid, the device having features comprising: a beam limiting aperture array in which are defined a plurality of apertures positioned so as to generate the grid of the plurality of beams; a plurality of strip arrays positioned along the paths of the plurality of beams, the strip arrays comprising electrodes extending across a path of the plurality of beams so as to operate on the beams that pass between adjoining electrode the respect strip array to collimate the path of the passing beams, and the orientation of the strips in the array of at least two different arrays along the beam path being different; and a controller configured to be connected to and apply a potential difference to the electrodes of the plurality of strips so that the plurality of strips collimate the grid, wherein the column at least one of the features has an adjusted characteristic configured to mitigate an aberration in the grid that is induced by passage of the plurality of beams through the plurality of strip arrays.

<u>BRIEF DESCRIPTION OF FIGURES</u>

The above and other embodiments of the present disclosure will become more apparent from the description of exemplary embodiments, taken in conjunction with the accompanying drawings.

**FIG. 1** is a schematic diagram illustrating an exemplary charged particle beam assessment (e.g. inspection) apparatus.

**FIG. 2** is a schematic diagram illustrating an exemplary multi-beam apparatus that is part of the exemplary charged particle beam assessment apparatus of **FIG. 1.**

**FIG. 3** is a schematic diagram of an exemplary multi-beam apparatus according to an embodiment.

**FIG. 4** is a schematic side view of an array of correctors.

**FIG. 5** is a schematic plan view of an array of correctors.

**FIG. 6** is a diagram explaining applied voltages in an array of correctors.

**FIG. 7** is a diagram explaining another arrangement of applied voltages in an array of correctors.

**FIG. 8** is a schematic plan view of a hexagonal array of correctors.

**FIG. 9A** is a schematic side view of an array of correctors. **FIG. 9B** provides plan views of the grid of charged particle beams as the charged particle beams pass through the array of correctors of **FIG. 9A. FIG 9C** provides plan views of the beams passing through the strip arrays without any adjustments of the embodiment. **FIG 9D** provides plan views of the beams passing through the strip arrays in accordance with the embodiment.

**FIG. 10A** is a schematic side view of an array of correctors. **FIG. 10B** provides plan views of the grid of charged particle beams as the charged particle beams pass through the array of correctors of **FIG. 10A. FIG 10C** provides plan views of the beams passing through the strip arrays without any adjustments of the embodiment. **FIG 10D** provides plan views of the beams passing through the strip arrays in accordance with the embodiment.

**FIG 11A** and **11B** show how calculations of trajectory shifts can be calculated.

**FIG. 12A** is a schematic side view of an array of correctors. **FIG. 12B** provides plan views of the grid of charged particle beams as the charged particle beams pass through the array of correctors of **FIG. 12A. FIG 12C** provides plan views of the beams passing through the strip arrays without any adjustments of the embodiment. **FIG 12D** provides plan views of the beams passing through the strip arrays in accordance with the embodiment.

The figures are schematic. The schematic diagrams and views show the components described below. However, the components depicted in the figures are not to scale. Relative dimensions of components in drawings are exaggerated for clarity. Within the following description of drawings the same or like reference numbers refer to the same or like components or entities, and only the differences with respect to the individual embodiments are described.

DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of substrate, devices (or columns), assemblies, arrays, apparatuses, systems and methods consistent with aspects and embodiments related to the invention as recited in the appended claims.

The enhanced computing power of electronic devices, which reduces the physical size of the electronic devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. Just one defect can cause electronic device failure. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection systems (such as a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate signal particles, e.g. secondary electrons and/or back-scatter electrons. The detection apparatus captures the signal particles from the sample as the sample is scanned so that the SEM can create an image of the scanned area of the sample. For high throughput inspection, some of the inspection apparatuses use multiple focused primary beams, i.e. a multi-beam, of primary electrons. The component beams of the multi-beam may be referred to as sub-beams or beamlets or an array of primary beams. A multi-beam can scan different parts of a sample simultaneously. A multi-beam assessment (or inspection) apparatus can therefore inspect a sample at a much higher speed than a single-beam assessment (or insepction) apparatus. An implementation of a known multi-beam assessment system is described below.

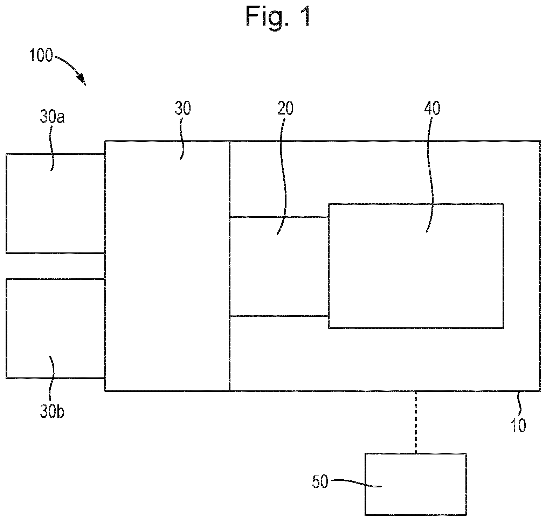

Reference is now made to **FIG. 1,** which is a schematic diagram illustrating an exemplary charged particle beam assessment system 100. The charged particle beam assessment system 100 of **FIG. 1** includes a main chamber 10, a load lock chamber 20, a charged particle beam apparatus 40 (which may otherwise be referred to as an electron beam apparatus, electron beam tool or charged particle beam tool), an equipment front end module (EFEM) 30 and a controller 50. The charged particle beam apparatus 40 is located within the main chamber 10. Such a charged particle apparatus 40 either is or comprises a charged particle device 41.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. After reaching the first pressure below the atmospheric pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second lower pressure. After reaching the second pressure, the sample is transported to the charged particle beam apparatus 40 by which it may be inspected. Depending on the configuration used, the second pressure may be deeper than between $10^{-7}$ to $10^{-5}$ mbar. A charged particle beam apparatus 40 may comprise a multi-beam charged particle optical device 41.

The controller 50 is electronically connected to the charged particle beam apparatus 40. The controller 50 may be a processor (such as a computer) configured to control the charged particle beam assessment (e.g. inspection) system 100. The controller 50 may include a processing circuitry configured to execute various signal and image processing functions. While the controller 50 is shown in FIG. 1 as being outside of the structure that includes the main chamber 10, the load lock chamber 20, and the EFEM 30, it is appreciated that the controller 50 may be part of the structure. The controller 50 may be located in one of the component elements of the charged particle beam assessment system100 or it can be distributed over at least two of the component elements. While the present disclosure provides examples of the main chamber 10 housing a charged particle beam assessment system 100, it should be noted that embodiments of the disclosure in their broadest sense are not limited to a chamber housing a charged particle beam assessment system 100. Rather, it is appreciated that the foregoing principles may also be applied to other tools and other arrangements of apparatus, that operate under the second pressure.

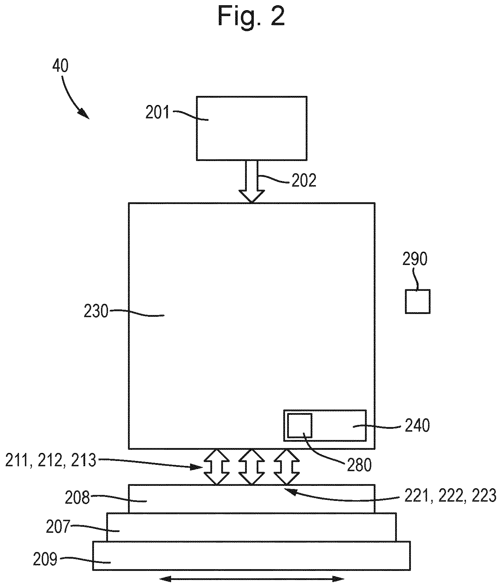

Reference is now made to **FIG. 2,** which is a schematic diagram illustrating an exemplary charged particle beam apparatus 40 that is part of the exemplary charged particle beam assessment system 100 of **FIG. 1.** The multi-beam charged particle beam apparatus 40 (also referred to herein as tool) comprises an charged particle source 201, a projection apparatus 230, an actuated stage 209, and a sample holder 207. The charged particle source 201 and projection apparatus 230 may together be referred to as an illumination apparatus. Features of the charged particle beam apparatus 40 not including the source 201 and the sample 208, sample holder 207 and actuated stage 209 may together be referred to as a charged particle device 41. The sample holder 207 is supported by actuated stage 209 so as to hold a sample 208 (e.g., a substrate or a mask) for inspection. The multi-beam charged particle beam apparatus 40 further comprises a detector array 240 (e.g. an electron detection device).

The controller 50 may be connected to various parts of the charged particle beam assessment system 100 of **FIG. 1.** The controller 50 may be connected to various parts of the charged particle beam apparatus 40 and/or the charged particle device 41 of **FIG. 2,** such as the charged particle source 201, the detector array 240, the projection apparatus 230, and the actuated stage 209. The controller 50 may perform various data, image and/or signal processing functions.

The controller 50 may also generate various control signals to govern operations of the charged particle beam assessment system 100, including the charged particle beam apparatus 40 and/or the charged particle device 41. The controller 50 may control the actuated stage 209 to move sample 208 during inspection of the sample 208. The controller 50 may enable the actuated stage 209 to move the sample 208 in a direction, for example continuously, for example at a constant speed, at least during sample inspection. The controller 50 may control movement of the actuated stage 209 so that it changes the speed of the movement of the sample 208 dependent on various parameters. For example, the controller 50 may control the stage speed (including its direction) depending on the characteristics of the inspection steps of scanning process.

The charged particle source 201 may comprise a cathode (not shown) and an extractor or anode (not shown). During operation, the charged particle source 201 is configured to emit charged particle (e.g. electrons) as primary charged particles from the cathode. The primary charged particles are extracted or accelerated by the extractor and/or the anode to form a primary charged particle beam 202. The charged particle source 201 may comprise multiple sources, such as described in EP20184161.6, which is hereby incorporated by reference at least with respect to the multiple sources and how they relate to multiple columns (or at least multiple charged particle devices 41) and their associated charged particle-optics.

The projection apparatus 230 is configured to convert the primary charged particle beam 202 into a plurality of sub-beams 211, 212, 213 and to direct each sub-beam onto the sample 208. Although three sub-beams are illustrated for simplicity, there may be many tens, many hundreds or many thousands of sub-beams. The sub-beams may be referred to as beamlets. Furthermore, although the present description and figures relate to a multi-beam system, a single beam system may be used instead in which the primary charged particle beam 202 is not converted into multiple sub-beams. The sub-beams may be generally interchangeable with a single primary charged particle beam 202. For example, a single beam system may be used as described in US 2021/0319977.

The projection apparatus 230 may be configured to focus sub-beams 211, 212, and 213 onto a sample 208 for inspection and may form three probe spots 221, 222, and 223 on the surface of sample 208. The projection apparatus 230 may be configured to deflect the primary sub-beams 211, 212, and 213 to scan the probe spots 221, 222, and 223 across individual scanning areas in a section of the surface of the sample 208. In response to incidence of the primary sub-beams 211, 212, and 213 on the probe spots 221, 222, and 223 on the sample 208, signal charged particles (e.g. electrons) are generated (i.e. emitted) from the sample 208 which include secondary signal particles and backscatter signal particles. The signal particles emitted from the sample, e.g. secondary electrons and backscatter electrons, may otherwise be referred to as charged particles, e.g. secondary charged particles and backscatter charged particles. Signal beams are formed of signal particles emitted from the sample. It will generally be understood that any signal beams emitted from the sample 208 will travel in a direction with at least a component substantially opposite to the charged particle beams (i.e. the primary beams), or will have at least a component of direction which is opposite to the direction of the primary beams. Signal particles, which are emitted by the sample 208 may also pass through the electrodes of the objective lens and would also be affected by the field.

The detector array 240 is configured to detect (i.e. capture) signal particles emitted from the sample 208. The detector array 240 is configured to generate corresponding signals which are sent to a signal processing system 280, e.g. to construct images of the corresponding scanned areas of sample 208. The detector array 240 may be incorporated into the projection apparatus 230, or may be separate therefrom, with a secondary optical column being provided to direct secondary signal particles to the detector array. The detector array may otherwise be referred to as a sensor array, and the terms "detector" and "sensor" and "sensor unit" are used interchangeably throughout the application.

The signal processing system 280 may comprise a circuit (not shown) configured to process signals from the detector array 240 so as to form an image. The signal processing system 280 could otherwise be referred to as an image processing system or a data processing system. The signal processing system may be incorporated into a component of the multi-beam charged particle beam apparatus such as the detector array 240 (as shown in **FIG. 2**). However, the signal processing system 280 may be incorporated into any components of the charged particle beam assessment system 100 (or charged particle beam apparatus 40 or charged particle device 41), such as, as part of the projection apparatus 230 or the controller 50. The signal processing system 280 may be located outside of the structure that includes the main chamber which is shown in **FIG. 1.** The signal processing system 280 may include an image acquirer (not shown) and a storage device (not shown). For example, the signal processing system may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector array 240 permitting signal communication, such as an electrical conductor, optical fiber cable, portable storage media, IR, Bluetooth, internet, wireless network, wireless radio, among others, or a combination thereof. The image acquirer may receive a signal from the detector array 240, may process the data comprised in the signal and may construct an image therefrom. The image acquirer may thus acquire images of the sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The signal processing system 280 may include measurement circuitry (e.g., analog-to-digital converters) to obtain a distribution of the detected secondary signal particles. The electron distribution data, collected during a detection time window, can be used in combination with corresponding scan path data of each of primary sub-beams 211, 212, and 213 incident on the sample surface, to reconstruct images of the sample structures under inspection. The reconstructed images can be used to reveal various features of the internal or external structures of the sample 208. The reconstructed images can thereby be used to reveal any defects that may exist in the sample.

Known multi-beam systems, such as the charged particle beam apparatus 40 and charged particle beam assessment system 100 described above, are disclosed in US2020118784, US20200203116, US 2019/0259570 and US2019/0259564 which are hereby incorporated by reference.

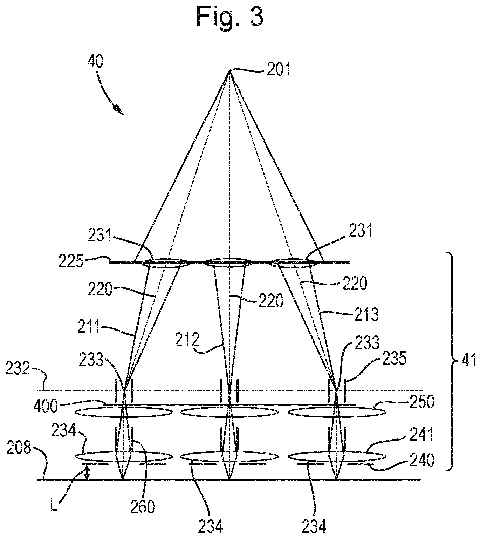

Components of an assessment apparatus 40 or charged particle device 41 (of, for example, or at least comprised in, an assessment system 100) which may be used in the present invention are described below in relation to **FIG. 3** which is a schematic diagram of a charged particle beam apparatus 40. The charged particle beam apparatus 40 of **FIG. 3** may correspond to the multi-beam charged particle beam tool (also referred to herein as apparatus. The charged particle assessment apparatus 40 may be, or may comprise a charged particle optical device 41. The charged particle optical device 41 may include some, for example all features between the source and facing a sample position, e.g. excluding the source 201, or all features described herein in for the charged particle assessment apparatus 40 such as depicted in **FIG. 3**. Note a sample position is the location or position that a sample 208 would have when held (or supported) by the sample holder 207.

The charged particle source 201 directs charged particles (e.g. electrons) toward an array of condenser lenses 231 (otherwise referred to as a condenser lens array) forming part of the projection system 230. The charged particle source 201 is desirably a high brightness thermal field emitter with a good compromise between brightness and total emission current. There may be many tens, many hundreds or many thousands of condenser lenses 231. The condenser lenses 231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The array of condenser lenses 231 may take the form of at least two plates, acting as electrodes, with an aperture in each plate aligned with each other and corresponding to the location of a sub-beam. At least two of the plates are maintained during operation at different potentials to achieve the desired lensing effect.

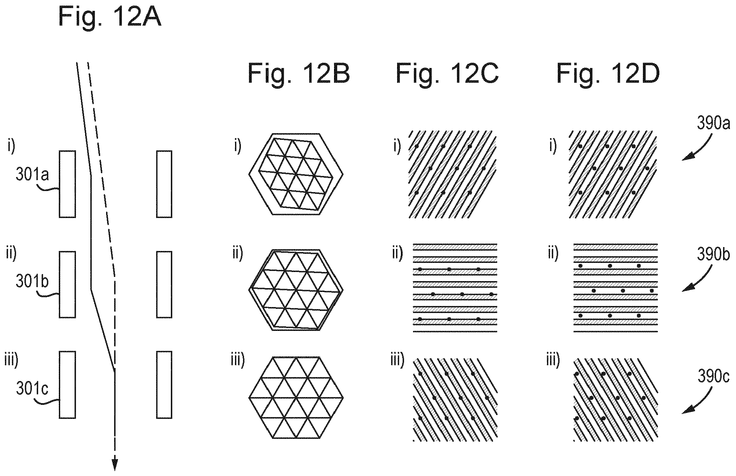

In an arrangement the array of condenser lenses 231 is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. which is herein incorporated by reference at least so far as the features of an objective lens array disclosed therein. There may be some variation for optimizing aberration corrections as described in EP Application 20207178.3 filed on 12 November 2020, for example in figure 12, which is herein incorporated by reference at least with respect to corrections achieved by varying aperture diameter.

Each condenser lens in the array may direct charged particles into a respective sub-beam 211, 212, 213 which is focused at a respective intermediate focus 233. The intermediate foci 233 (or intermediate focuses) may be in a plane of intermediate focus. At the intermediate foci 233 are deflectors 235, for example at the plane of intermediate focus or at the position of the intermediate foci along the paths of the respective sub-beams 211 . Deflectors 235 are configured to operate on a respective sub-beam 211, 212, 213 for example to bend a respective sub-beam 211, 212, 213 (or deflect a path of the respective sub-beam) by an amount effective to ensure that the path of the sub-beam (or alternatively expressed the principal ray path of the sub-beam) is incident on the sample 208 substantially normally (which is an example of a trajectory at substantially 90° to a nominal surface of the sample or a surface at the sample position or coplanar with the sample position such as a sensor surface in the stage and adjoining the sample holder). That is the axis of the sub-beam path with respect to the sample position, at least down beam of the deflectors 235, is substantially normal to a plane orthogonal to the multi-beam path at the sample position. Deflectors 235 may also be referred to as collimators. Down beam of the intermediate foci 233 are the plurality of objective lenses 234. Each objective lens 234 directs a respective sub-beam 211, 212, 213 onto the sample 208. Objective lenses 234 can be configured to de-magnify the electron beam by a factor greater than 10, desirably in the range of 50 to 100 or more.

Voltage sources (which may be provided by individual electric power sources, or may all be supplied by electric power source 290) may be used to apply potentials to at least one electrode of the objective lens array 241, at least one electrode of the control lens 250 and/or to the sample to control projection of the primary beam(s) through the objective lens array 241, as described in EP Application 20207178.3 filed on 12 November 2020, for example in figure 14, and in EP 21174518.7 filed 18 May 2021. Variation in the potentials can be used for different landing energies, to control the beam opening angle and/or the focus of the primary beam on the sample. The potentials may be controlled to accelerate or decelerate the primary beam through the objective lens array 241 towards the sample.

The detector array 240 (which may otherwise be referred to as an array of detectors) comprises a plurality of detectors. Each detector is associated with a corresponding sub-beam (which may otherwise be referred to as a beam or primary beam). In other words, the arrays of detectors (i.e. the detector array 240) and sub-beams correspond. Each detector may be assigned to a sub-beam. The array of detectors may correspond with the array of objective lenses. In other words, the array of detectors may be associated with the corresponding array of objective lenses. A detector array 240 is described below. However, any reference to detector array 240 may be replaced with a single detector (i.e. at least one detector) or multiple detectors as appropriate. The detectors may otherwise be referred to as of detector elements (e.g. sensor elements such as capture electrodes). The detectors may be any appropriate type of detector.

The detector array 240 may be positioned at a position along the primary beam path at any location between an up-beam position and a down-beam position along the beam path. The up-beam position is above the objective lens array and optionally any associated lens arrays such as a control lens array (i.e. up beam of an objective lens array assembly). The down-beam position is down beam of the objective lens array. In an arrangement the detector array may be an array that is up beam of the objective lens array assembly. The detector array may be associated with any electrode of the objective lens array assembly. Reference hereafter of a detector in association with an electrode of the objective lens array may correspond to an electrode of the objective lens array assembly, except for the most down beam surface of the most down beam electrode of the objective lens array, unless stated explicitly otherwise.

In an arrangement the detector array 240 may be positioned between the control lens array 250 and the sample 208. The detector array 240 may be positioned between the objective lenses 234 and the sample 208, as shown in **FIG. 3.** Although this may be desirable, the detector array 240 could be provided in additional or alternative locations. Multiple detector arrays may be provided in a variety of locations.

The detector array 240 may be positioned proximate and/or adjacent the sample. The detector being proximate and/or adjacent the sample enables the risk of cross-talk in detection of signal particles generated by sub-beams which correspond to another detector in the detector array to be reduced if not avoided.

Desirably, a distance 'L' as shown in **FIG. 3,** between the detector array 240 and the sample 208 is between approximately 20 to 100 $\mu$m, i.e. the detector array 240 is positioned within approximately 20 to 100 $\mu$m for example from the sample 208. Generally the distance L is small so as to ensure detector efficiency and/or reduce cross-talk, for example between 5 and 200 $\mu$m. The distance L is determined as the distance from a surface of the sample 208 facing the detector array 240 and a surface of the detector array 241 facing the sample 208.

In an embodiment, the objective lens array 241 is an exchangeable module, either on its own or in combination with other elements such as the control lens array and/or detector array. The exchangeable module may be field replaceable, i.e. the module can be swapped for a new module by a field engineer. In an embodiment, multiple exchangeable modules are contained within the apparatus 40 and can be swapped between operable and non-operable positions without opening the apparatus 40.

In some embodiments, one or more aberration correctors are provided that reduce one or more aberrations in the sub-beams. The one or more aberration correctors may be provided in any of the embodiments, e.g. as part of the charged particle optical device 41, and/or as part of an optical lens array assembly, and/or as part of an assessment apparatus 40. In an embodiment, each of at least a subset of the aberration correctors is positioned in, or directly adjacent to, a respective one of the intermediate foci 233 (e.g. in or adjacent to the intermediate image plane 232 or plane of intermediate focus). The sub-beams have a smallest cross-sectional area in or near a focal plane such as the intermediate plane 232. This provides more space for aberration correctors than is available elsewhere, i.e. up beam or down beam of the intermediate plane (or than would be available in alternative arrangements that do not have an intermediate image plane).

In an embodiment, aberration correctors positioned in, or directly adjacent to, the intermediate foci 233 (or intermediate image plane 232) comprise deflectors to correct for the source 201 appearing to be at different positions for different sub-beams. Correctors can be used to correct macroscopic aberrations resulting from the source that prevent a good alignment between each sub-beam and a corresponding objective lens.

The aberration correctors may correct aberrations that prevent a proper column alignment (or alignment of charged particle elements along the beam path of the charged particle device 41 from source to sample position). Such aberrations may also lead to a misalignment between the sub-beams and the correctors. For this reason, it may be desirable to additionally or alternatively position aberration correctors at or near the condenser lenses 231 (e.g. with each such aberration corrector being integrated with, or directly adjacent to, one or more of the condenser lenses 231). This is desirable because at or near the condenser lenses 231 aberrations will not yet have led to a shift of corresponding sub-beams because the condenser lenses are vertically close or coincident with the beam apertures. A challenge with positioning correctors at or near the condenser lenses 231 (e.g. just below the condenser lenses in **FIG. 3**)**,** however, is that the sub-beams 212, 213, 214 each have relatively large cross-sectional areas and relatively small pitch at this location, relative to locations further downstream. The condenser lenses and correctors may be part of the same structure. For example they may be connected to each other, for example with an electrically isolating element. The aberration correctors may be CMOS based individual programmable deflectors as disclosed in EP2702595A1 or an array of multipole deflectors as disclosed EP2715768A2, of which the descriptions of the sub-beam manipulators in both documents are hereby incorporated by reference.

In some embodiments, each of at least a subset of the aberration correctors is integrated with, or directly adjacent to, one or more of the objective lenses 234. In an embodiment, these aberration correctors reduce one or more of the following: field curvature; focus error; and astigmatism. Additionally or alternatively, one or more scanning deflectors (not shown) may be integrated with, or directly adjacent to, one or more of the objective lenses 234 for scanning the sub-beams 211, 212, 213 over the sample 208. In an embodiment, the scanning deflectors described in US 2010/0276606, which document is hereby incorporated by reference in its entirety, may be used.

In an embodiment the objective lens referred to in earlier embodiments is an array objective lens. Each element in the array is a lens (which may be referred to as a micro-lens in view of its size) operating a different beam or group of beams in the multi-beam. An electrostatic array objective lens has at least two plates each with a plurality of holes or apertures. The position of each aperture in a plate corresponds to the position of a corresponding aperture in the other plate. The corresponding apertures operate in use on the same beam or group of beams in the multi-beam. A suitable example of a type of lens for each element in the array is an two electrode decelerating lens. The bottom electrode of the objective lens may be a detector substrate such as a CMOS chip detector integrated into a multi-beam manipulator array. (Alternatively or additionally the detector array is in a plate associated with and separate from the bottom electrode). Integration of a detector array into the objective lens replaces a secondary column. The detector array is desirably orientated to face the sample (because of the small distance (e.g. less than 200 □m for example between 10 □m and 100 □m) between sample 208 and bottom of the electron-optical system for example the charged particle device 40). In an embodiment, electrodes to capture the secondary electron signals are formed in the top metal layer of the detector array e.g. CMOS device. The electrodes can be formed in other layers. Connection to the detector electrodes of the detector array may be via designated electrical connections through the detector substrate, such as through-silicon vias for connected to CMOS elements for example in specific CMOS layers. Power, control and detection signals of the detector array to and from the detector elements and features may be connected to such through substrate electrical connections. Such power and signals may be connected to CMOS features by the through-silicon vias. For robustness, desirably the bottom electrode consists of two elements: the CMOS chip and a passive Si plate with apertures. The plate shields the detector features in the detector substrate, for example of CMOS, from high E-fields.

In order to maximize the detection efficiency it is desirable to make the electrode surface as large as possible, so that substantially all the area of the array objective lens (except the apertures) is occupied by electrodes and each electrode has a diameter substantially equal to the array pitch. In an embodiment the outer shape of the electrode is a circle, but this can be made a square to maximize the detection area. Also the diameter of the through-substrate aperture can be minimized. A typical size, for example cross-sectional dimension, of the electron beam is in the order of 5 to 15 □m.

In an embodiment, a single electrode surrounds each aperture. In another embodiment, a plurality of electrode elements are provided around each aperture. The signal particles, e.g. electrons, captured by the electrode elements surrounding one aperture may be combined into a single signal or used to generate independent signals. The electrode elements may be divided radially (i.e. to form a plurality of concentric annuluses), angularly (i.e. to form a plurality of sector-like pieces), both radially and angularly or in any other convenient manner.

However a larger electrode surface leads to a larger parasitic capacitance, so a lower bandwidth. For this reason it may be desirable to limit the outer diameter of the electrode. Especially in case a larger electrode gives only a slightly larger detection efficiency, but a significantly larger capacitance. A circular (annular) electrode may provide a good compromise between collection efficiency and parasitic capacitance. A larger outer diameter of the electrode may also lead to a larger crosstalk (sensitivity to the signal of a neighboring aperture). This can also be a reason to make the electrode outer diameter smaller. Especially in case a larger electrode gives only a slightly larger detection efficiency, but a significantly larger crosstalk. The signal charged particle current collected by electrode may be amplified by a Trans Impedance Amplifier (or TIA). The TIA and associated electric circuitry may be incorporated in the detector substrate for example in CMOS.

Any appropriate variation in the apparatus 40 or device 41 may be implemented. For example, the macro-collimator may be partially or wholly replaced by a collimator element array provided down-beam of the up-beam limiter. For example, a macro scan deflector may be provided to cause sub-beams to be scanned over the sample 208. For example, the macro scan deflector may be partially or wholly replaced by a scan deflector array 260.

In other embodiments both a macro scan deflector and the scan-deflector array are provided. In such an arrangement, the scanning of the sub-beams over the sample surface may be achieved by controlling the macro scan deflector and the scan-deflector array 260 together, desirably in synchronization.

The invention can be applied to various different apparatus architectures. For example, the charged particle beam apparatus may be a single beam apparatus, or may comprise a plurality of single beam columns or may comprise a plurality of columns of multi-beams (i.e. sub-beams). The columns may comprise the charged particle optical device described in any of the above embodiments or aspects. As a plurality of columns (or a multi-column apparatus), the devices may be arranged in an array which may number two to one hundred columns or more. The charged particle optical device may be a charged particle optical column. A charged particle column may optionally comprise a source.

If multiple detector arrays are provided, they may be configured to detect signal particles simultaneously. The detectors may be positioned to face up-beam of the primary beam paths 320. In other words, the detectors may be configured to face along the primary beam path 320 towards a source of the primary beam (described above as source 201), i.e. away from the sample 208. The detectors may be configured to face towards the sample, i.e. in the direction of the sample 208. In other words, the detectors may be facing in a direction along the primary beam path 320 towards the sample 208, i.e. away from the source.

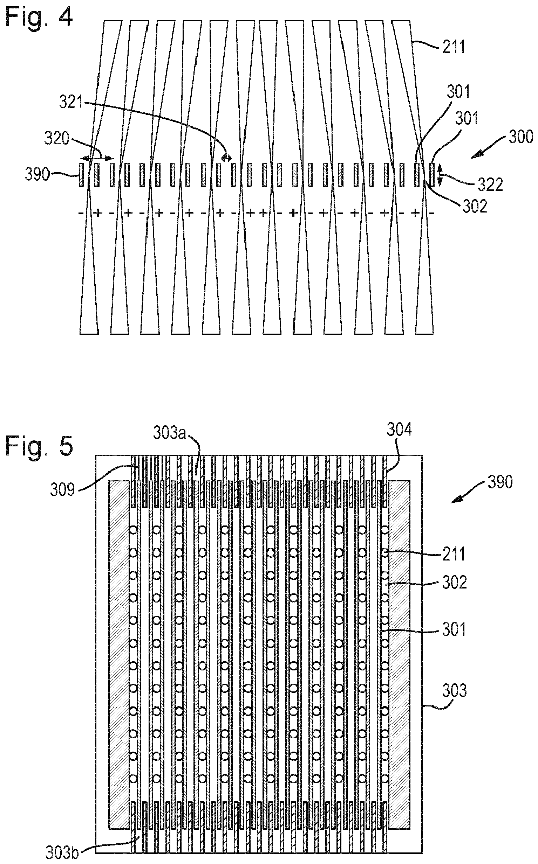

The correctors at the intermediate focuses 233 can be embodied by a deflector 300. Deflector 300 is an example of a manipulator and may also be referred interchangeably to as a strip or slit corrector, or a strip or slit deflector. In an arrangement the deflector 300 may comprise part of a collimator array (for example as a deflector array 235 as described elsewhere herein) or adjoin a collimator array, or a part of such a collimator, as a corrector in the beam path, for example adjacently. As shown in **FIGs 4** and **5,** deflector 300 comprises a strip array 390. **FIGs 4** and **5** show a single strip array 390, however, additional strip arrays can be provided in the deflector 300, as described below. The strip array 390 comprises a set of elongate electrodes 301. The elongate electrodes may otherwise be referred to as plates or strips interchangeably, and are desirably substantially parallel with each other. Thus, the strip array 390 may comprise an array elongate electrodes 301. The strip array 390 may define a set of slits 302. The slits 302 may be formed between the elongate electrodes 301. Desirably a slit is defined between facing surfaces of adjacent elongate electrodes in a strip array. Thus, the surface of two adjacent elongate electrodes which are opposite to each other and between which the beam passes through can be referred to as facing surfaces. The elongate electrodes may be electrostatic. The electrostatic effect is provided by these facing surfaces. The strip array 390 may have one or more electrical connection, for example to each electrode. A potential difference may be applied to the elongate electrodes, for example each elongate electrode. The applied potential may be similar for alternating elongate electrodes or at least alternating polarity. The set or array of elongate electrodes 301 may be in a common plane. The common plane of the array of elongate electrodes 301 (i.e. of the strip array 390) may be orthogonal to the beam path, for example of the multi-beam arrangement, that may be the beam path considering the overall beam path of the multi-beam arrangement and thus representative of all the sub-beams of the multi-beam arrangement. The elongate electrodes 301 may have planar surfaces, desirably directly facing the sub-beam paths. Thus, the facing surface are desirably substantially planar. The planar surfaces of the elongate electrodes 301 may be mutually parallel. The elongate electrodes 301 may be equidistantly spaced relative to each other and for example relative to the sub-beams of the multi-beam arrangement, as depicted. The elongate electrodes 301 may be orthogonal to the sub-beam paths of the multi-beam arrangement, for example when collimated. The planar surfaces of the elongate electrodes 301 may be substantially aligned with the paths of the sub-beams of the multi-beam arrangement, for example when collimated. The elongate electrodes 301 may be formed of silicon or a metal, for example doped silicon regions of a substrate and metallization layers formed on a substrate. Silicon electrodes can be formed by selective etching of a silicon wafer.

As shown in **FIG 4,** the elongate electrodes 301 have a depth shown by arrow 322 in the beamwise direction, which is the thickness of the elongate electrode. This may otherwise be referred to as the thickness of the strip array. The distance between facing surfaces of adjacent elongate electrodes 301 is shown by arrow 321. The pitch between adjacent sub-beams is shown by arrow 320. Desirably, the pitch between electrodes on the same side of respective adjoining sub-beams may correspond to the pitch 320 between adjacent sub-beams.

Figure 5 shows an arrangement for mounting elongate electrodes to form a possible configuration of the strip array 390. A frame 303, e.g. of ceramic such as glass, is provided to support the elongate electrodes 301. Shields 304, e.g. of ceramic such as glass, can be provided at the ends of the elongate electrodes 301 to prevent surface creep or breakdown when high-voltages are provided to the elongate electrodes. As depicted, elongate electrodes 301 extend across the frame 303, for example between facing sides of the frame. The elongate electrodes 301 may extend between the sub-beam paths across a multi-beam arrangement of sub-beams 211, for example as a line of sub-beam paths, such as depicted. Electric potentials are provided to the elongate electrodes 301 through conductive traces 309 (for clarity only a few are shown in the figure). The shields 304 protrude from sides 303a, 303b of the frame 304 to which the electrodes of the array are mounted. The shields interpose between adjacent electrodes suppressing high voltage discharge between adjacent elongate electrodes 301 by increasing the creep length between adjacent elongate electrodes 301.

A deflector 300 functioning as aberration correctors may alternatively or in addition be positioned just below the condenser lenses 231. This can be advantageous in that any angular error to be corrected will not have been translated into a large positional shift. Such aberration correctors may correct aberrations that prevent a proper column alignment. Such aberrations may also lead to a misalignment between the sub-beams 211, 212, 213 and the correctors 235. For this reason, it may be desirable to additionally or alternatively position aberration correctors at or near the condenser lenses 231 (e.g. with each such aberration corrector being integrated with, or directly adjacent to, one or more of the condenser lenses 231). This is desirable because at or near the condenser lenses 231 aberrations will not yet have led to a shift of corresponding sub-beams 211, 212, 213 because the condenser lenses 231 are vertically close or coincident with the beam apertures.

A line of sub-beam paths, for example for the sub-beams in operation of the assessment apparatus, interposes a pair of elongate electrodes 301, i.e. between adjacent elongate electrodes of a strip array, so that a potential difference between the elongate electrodes 301 causes a deflection of the sub-beams. The direction of the deflection is determined by the relative polarity of the potential difference in a direction relative to the optical axis (i.e. the beam path). The magnitude of the deflection is determined by the magnitude of the potential difference, the distance between the electrodes (as shown by arrow 321 in **FIG 4**) and the length of the electrodes, i.e. thickness, in the direction parallel to the propagation of the sub-beams (as shown by arrow 322 in **FIG 4**). These dimensions may be referred to as the width and depth of the slit, respectively. In an embodiment the width of the slits is in the range of from 10 to 100 □m. In an embodiment the pitch of the slits (i.e. the distance between the centre of a slit and the centre of the next slit) is in the range of from 20 to 200 □m. In an embodiment, the depth of the slit is in the range of from 50 to 400 □m, desirably 100 to 300Dm.

In an embodiment, the elongate electrodes are at the same potential along their lengths and the slit (i.e. the gap between facing surfaces of adjacent electrodes) is of constant width and depth so that all sub-beams passing through a given slit experience substantially the same deflection as they all have substantially the same energy.

In an embodiment, the facing surfaces of the electrodes (e.g. which define a slit) may have a non-constant cross-section, e.g. a variation in width or depth, to provide a predetermined variation in the deflection in the sub-beams according to their position along the length of the electrode.

In an embodiment, the elongate electrodes 301 define a set of parallel slits such that each of the sub-beams pass through a slit. The facing surface of each elongate electrode that in part defines a slit may have a planar surface that may be parallel with a sub-beam path. Thus, facing surfaces of the respective elongate electrodes define a corresponding slit. The facing surfaces of electrodes defining a slit may each be planar and mutually parallel. The facing surface, and thus the slit, may extend across the array of sub-beam paths, for example across the multi-beam arrangement, for example as depicted in **FIG. 5** in reference to **FIG. 4**. Desirably the potentials applied to each electrode surface are individually controllable so that the deflection can be controlled as a function of beam position in a direction perpendicular to the longitudinal direction of the elongate electrodes/slits. In an embodiment a predetermined set of voltages are applied to the elongate electrodes to provide a predetermined set of deflections. For example if the elongate electrodes (and thus, the slits) extend in along a Y axis of a Cartesian coordinate system (i.e. the elongate direction of the electrodes is in a Y direction), deflection can be controlled as a function of sub-beam position in an X direction.

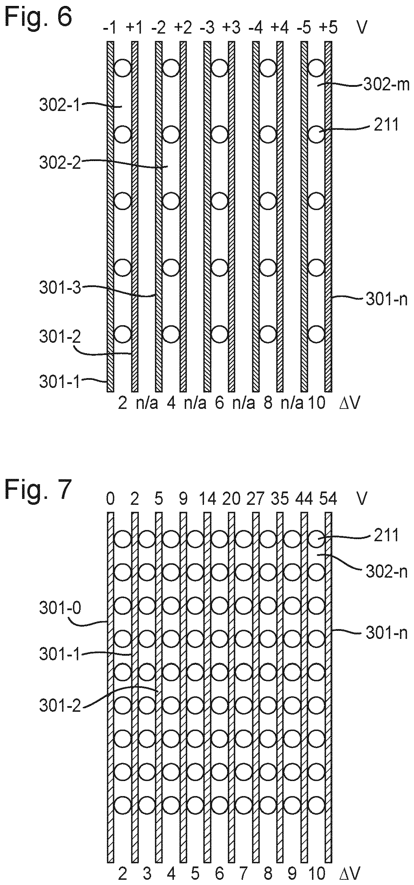

In an embodiment, facing surfaces of two dedicated elongate electrodes may define a slit. For example, as shown in **FIG. 6,** opposing surfaces of the elongate electrodes 301-1 and 301-2 define slit 302-1, opposing surfaces of elongate electrodes 301-3 and 301-4 define slit 302-2, etc. so that elongate electrodes 301-(2m-l) and 301-2m define slit 302-m. Opposite potentials are applied to alternate electrodes, for example odd-numbered elongate electrodes are negative and even numbered electrodes are positive. The magnitudes of the applied potentials can be varied with position so as to provide a desired deflection that varies with position in the direction perpendicular to the length of the electrodes. For example, as shown in **FIG. 6,** the potential (indicated at the top of the figure) increase linearly and the potential differences (indicated at the bottom of the figure) likewise increase linearly. For example, one set of elongate electrodes, e.g. the even ones, can be kept at a constant potential, e.g. ground.

Although exemplary potentials and variations are shown in **FIG. 6,** it will be understood that any appropriate potential might be applied to the electrodes. In an embodiment, for example in a central part of a strip array 390, the voltages may be centered around 0V. For example, the voltages of electrodes (with two central electrodes having 0 potential) may be -3,+3,-2,+2,-1,+1,0,0,+1,-1,+2,-2,+3,-3. Of course, fewer or additional electrodes may be included.

In an alternate embodiment, each elongate electrode (except for the electrodes at the end of the array) serves to define one side of each of two slits. That is, each side of the electrode forms a facing surface which defines a slit. That is, in general, the opposite surfaces of the elongate electrodes extending in the direction of the beam paths define in part adjoining slits. For example, as shown in **FIG. 7,** slit 302-1 is defined by the surfaces of electrodes 301-0 and 301-1, slit 302-2 is defined by facing surface of electrodes 301-1 and 301-2, etc., so that slit 302-n is defined by the surface of electrodes 301-(n-l) and 301-n. In such an arrangement, the potential applied to electrode 302-n relative to the potential applied to electrode 302-0 is the sum of the potential differences applied across slits 302-1 to 302-n. A linear increase in potential differences therefore results in the absolute potentials applied to the electrodes increasing more quickly than linear. In general, in an arrangement as shown in **FIG. 7** the potential differences increase monotonically across the array.

Although exemplary potentials and variations are shown in **FIG. 7,** it will be understood that any appropriate potential might be applied to the electrodes. In an embodiment, for example in a central part of a strip array 390, the voltages may be centered around 0V. For example, the voltages of electrodes (with two central electrodes having 0 potential) may be -6,-3,-1,0,0,-1,-3,-6. Of course, fewer or additional electrodes may be included.

There does not have to be acceleration or deceleration of the charged particle beam through the strip array 390, but there can be acceleration or deceleration in some arrangements.

The potentials may be applied to converge and/or diverge the sub-beams as they pass through the strip array 390.

An advantage of the arrangement of **FIG. 6,** compared to that of **FIG. 7,** is that the magnitudes of the potentials applied to the electrodes need be no greater than the potential differences required to achieve the desired deflections. An advantage of the arrangement of **FIG. 7,** compared to that of **FIG. 6,** is that fewer elongate electrodes are required so that the corrector can be made more compact. The arrangement of **FIG. 7** is advantageous if the corrector is positioned close to condenser lenses 231 because the sub-beams are closer together and the arrangement of **FIG. 7** can be made with a small distance between slits. Either of these arrangements may be used in the embodiments of the present invention and may be interchangeable.

In an embodiment, a plurality of strip arrays are provided. The plurality of strip arrays may be provided adjacent to each other in the beam propagation direction. Such an arrangement may be referred to as a stack of strip arrays. Desirably, the strip arrays in a stack are differently oriented. That is, at least two strip arrays in the plurality of strip arrays are provided at different orientations to each other.

In an embodiment, the sub-beams are arranged in a rectangular (or square) array and two strip arrays are provided with the electrodes of a first strip array being oriented perpendicularly to the electrodes of the second strip array. For example the first strip array has electrodes extending in the Y direction and provides a deflection in the X direction controllable as a function of sub-beam position in the X direction. The second strip array has electrodes extending in the X direction and provides a deflection in the Y direction controllable as a function of sub-beam position in the Y direction. The strip array may be provided in any order in the stack. Further details of a strip array/slit deflector may be found in EPA20156253.5, in which the description of a multi-beam deflector apparatus is hereby incorporated by reference.

In an embodiment, the sub-beams are arranged in a hexagonal array and two strip arrays are provided. The electrodes of the first strip array are orthogonal to the electrodes of the second strip array. For example the first strip array has electrodes extending in the Y direction and provides a deflection in the X direction controllable as a function of sub-beam position in the X direction. The second strip array has electrodes extending in the X direction and provides a deflection in the Y direction controllable as a function of sub-beam position in the Y direction. The second strip array has a smaller pitch than the first strip array and fewer sub-beams per slit than the first strip array. The strip array may be provided in any order in the stack.

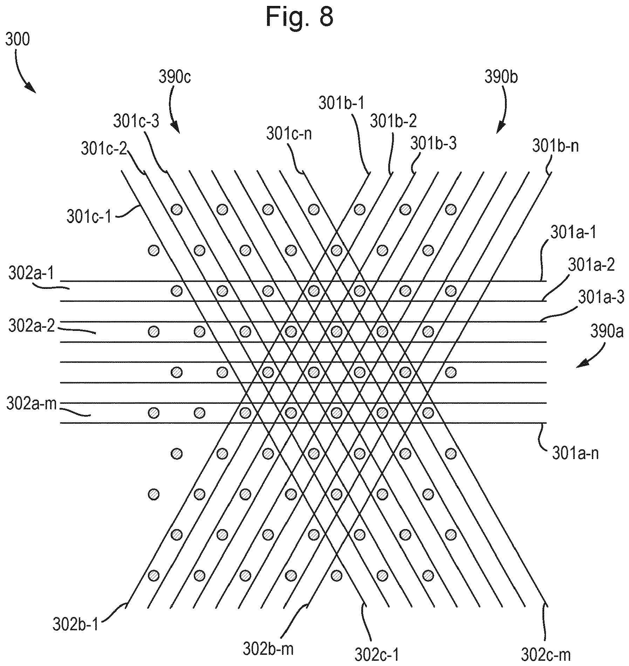

In an embodiment, the sub-beams are arranged in a hexagonal array and three strip arrays in a stack are provided. The three strip arrays are arranged such that there is a 60° angle between electrodes of the different strip array. For example as shown in **FIG. 8,** a first strip array 390a may have electrodes 301a oriented parallel to the X axis (0°), a second strip array 390b may have electrodes 301b at +60° to the X axis and a third strip array 390c may have electrodes 301c at -60° to the X axis. The strip arrays may be provided in any order in the stack. By suitable application of potentials to the electrodes defining the slits 302a, 302b, 302c, a desired deflection in any direction can be achieved as disclosed in EPA20156253.5. Of that document the disclosure of a hexagonal array of three strip arrays/slit deflectors is hereby incorporated by reference. In an arrangement, although a regular hexagonal array has been described, the same type of corrector may be achieved in an irregular array in which a strip array is arranged to correspond with the three axes of the irregular hexagonal array.

Even though the deflector 300 described above is useful for redirecting the sub-beams towards the sample 208, there is still room for improvement by adapting the above-described deflector 300 as described below.

Current single-beam assessment systems (for example that use SEMs) have orders of magnitude which are often too low to meet the throughput requirements for applications of sample assessment for example in high volume manufacturing applications. It is therefore beneficial to provide a charged particle device architecture or design capable of achieving the desired throughput. Such a charged particle apparatus may use a multibeam charged particle device architecture for example as a single charged particle device array or a plurality of such charged particle devices for example arranged in an array such as an two dimensional array of charged particle devices. For reasons of minimizing the space between the individual sub-beams, it may be beneficial to provide the constituent beams of the multi-beams in a hexagonal grid (or beam grid or multi-beam arrangement), as described herein. However, there may be disadvantages to using the deflector 300 described above for such a beam grid (which may be hexagonal).

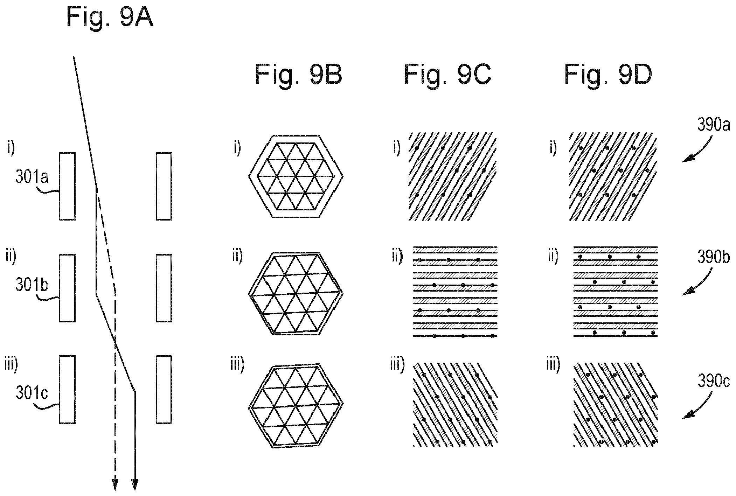

Although the deflector 300 can collimate the sub-beams with respect to each other, this is at the cost of a shift (in other words, a perturbation) of the trajectory of the sub-beams from respective ideal paths (i.e. the desired trajectories of the beams). **FIG. 9A** illustrates, in a sketch, a sub-beam trajectory between the electrodes of the three strip arrays.

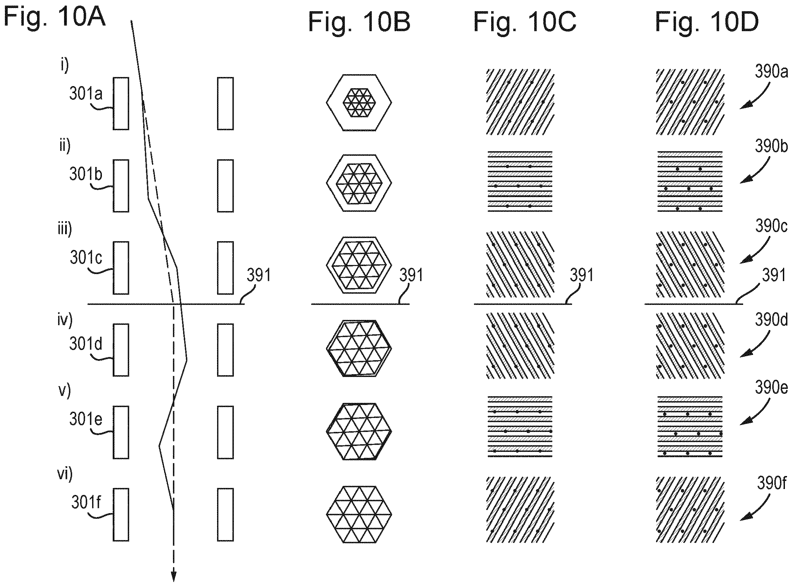

For convenience, in each of the three sets of figures **FIG 9A9D, 10A-10D, and 12A-12D,** each figure corresponds to a strip array in a strip array stack. Thus, the figures show sub-beams passing through the strip arrays. The strip arrays at different locations in the stack are labelled in **FIG 9A9D, and 12A-12D** with small case Roman numerals, specifically as i) through to iii) and in **FIG 10A-10D,** i) through to vi). Additionally, the electrodes 301a, 301b, 301c etc in all three sets of figures are oriented in three different directions in i), ii) and iii), for simplicity the relevant electrodes are indicated as rectangular cross sections in the same plane. Each electrode pair for each different strip array shown causes a deflection to the trajectory, here represented as sharp turns. The desired trajectory is shown with a dashed arrow and the actual trajectory is shown with a solid arrow. The desired trajectory is the preferred trajectory of a sub-beam so that it lands on the sample position in the desired position.

As described, a plurality of beams are projected towards the sample position. The plurality of beams, for example of a multi-beam arrangement are arranged in a grid. The grid is the position of sub-beams in a plane for example orthogonal to the path of the multi-beam arrangement. The grid may represent the arrangement of the sub-beams at a position along the path of the multi-beam arrangement. The plane of the grid is across the plurality of beams (rather than in the direction of the beams). The plane of the grid may be substantially parallel to the beam limiting aperture array and/or the strip arrays. The plane of the grid may be substantially parallel to the sample, the sample position and/or sample holder.

The grid can be formed by the beam limiting aperture array based on the specific position of the sub-beams. At the sample position, the sub-beams are ideally positioned in a desired location. If the sub-beams are all located at the correct positions, the grid at the sample position is the ideal grid. A desired grid is the grid up-beam of the sample with the sub-beams positioned in the desired position so that sub-beams incident on the sample position are in an ideal grid. In other words, the desired grid is the preferred position of the sub-beams so that the sub-beams are positioned at the desired location at the sample position, i.e. in an ideal grid when incident on the sample 208 when in place. Ideally, the desired grid is a scaled version of the ideal grid at generation of the sub-beams. Thus, if all the sub-beams were projected along their respective desired trajectories, the desired grid would result in each sub-beam being positioned correctly at the sample, i.e. in the ideal grid. The desired grid is the position of the sub-beams in the grid to obtain the ideal grid at the sample position.

However, even when the grid generated up-beam is a scaled version of the ideal grid, variations, perturbations, aberrations or distortions in the position of at least one of the plurality of beams in the grid will mean that the position of the sub-beams down-beam, e.g. down-beam of the plurality of strip arrays 390, no longer match results in formation of the ideal grid at the sample position. In other words, the actual trajectory of at least one of the beams no longer matches the desired trajectory, e.g. is offset from the desired trajectory. Characteristics of the actual grid (e.g. down-beam of the strip arrays 390) relate to variations, perturbations, aberrations or distortions in the position of at least one of the plurality of beams in the grid, i.e. when viewed in the grid plane. In other words, a characteristic of the grid may otherwise be defined as an aberration or perturbation in the grid at some point along the sub-beam paths, i.e. a difference between the actual grid and the desired grid.

The desired grid (and the ideal grid) may be a standard grid. Such a standard grid is a hypothetical grid with a rotationally symmetric pattern, and may be a grid as normally used in known art. Desirably, the standard grid has at least threefold, fourfold or sixfold symmetry. Desirably, the standard grid is substantially hexagonal as described above. The embodiments described herein are for use with a substantially hexagonal standard grid. However, the grid could be provided in another standard arrangement, for example, a grid with fourfold symmetry such as a rectangular or square grid as described above; alternative embodiments or variations of the embodiments may be provided for use with such a rectangular or square grid as mentioned further below. (Furthermore, as described in relation to further aspects below, the desired grid may not be the standard grid.)

In further detail, FIG 9A shows a sub-beam passing through elongate electrodes 301a, 301b and 301c, where the elongate electrodes will each be part of separate strip arrays, e.g. 390a, 390b, 390c. As described above, the strip arrays can be provided in different orientations from each other. The sub-beam as it passes through electrode 301a is shown in i); the sub-beam as it passes through 301b is shown in ii); and the sub-beam as it passes through 301c is shown in iii). The desired trajectory of the sub-beam is shown with a dashed arrow, and the actual trajectory of the sub-beam is shown with a solid arrow. **FIG 9B** shows the variation of the grid of sub-beams (or beam grid) as the sub-beams pass through the different strip arrays. Each intersection of the lines of the beam grid in **FIG. 9B** corresponds to the position of a sub-beam in the beam grid. For example, the grid shown in i) corresponds to the sub-beams passing through electrode 301a; the grid shown in ii) corresponds to the sub-beams passing through electrode 301b; the grid shown in iii) corresponds to the sub-beams passing through electrode 301c. Without any adjustment, deflections of the sub-beam as it passes through the electrodes lead to variations in the actual beam trajectory from the desired beam trajectory (as shown in **FIG 9A).** This is also shown in the change in shape of the grid in **FIG 9B.** This means that the relative positions of the sub-beams of the grid and the elongate electrodes of the strip arrays are as shown in **FIG 9C.** As shown, the deflection of the sub-beams means that there is collision with the elongate electrodes in multiple places. This is described further below. The present invention provides adaptations which can reduce or avoid such collisions as shown in **FIG 9D,** which is also described further below.

By design, the sum of the deflections cancels the initial slope of the trajectory (i.e. the angle of a sub-beam trajectory on entry to the deflector 300 compared to a direction orthogonal to the plane of the sample position, which might for example be a vertical line in **FIG 9A).** Consequently the sub-beam leaves the deflector 300 collimated with respect to the trajectories of other sub-beams and/or in a direction orthogonal to the plane of the sample position. However, because the collimation is distributed over multiple layers (i.e. over multiple strip arrays), the sub-beam is displaced from its design path. Thus, the sub-beam exiting the lowermost (i.e. most down-beam) electrode pair 301c (in iii)) has a displacement from the desired trajectory. Different sub-beams experience shifts of different magnitudes and in different directions, for example within the beam grid. For typical deflector 300, 235 dimensions, the shifts in the sub-beam positions within the beam grid may be the same order of magnitude or even approximately the same dimension of the width of the slits between facing surfaces of electrodes of the strip array. For example in an embodiment the least desirable shifts are of the order of 5 to 20 $\mu$m. This may be problematic because in such a design, the width of the slits between facing surfaces of electrodes of the strip array may only be only about 15 $\mu$m. Hence, with such deviations of sub-beam position, e.g. 5-20 um deviations, there is a risk that at least some of the sub-beams collide with the electrodes in the most down-beam strip array, or even the middle strip array, and shown in **FIG. 9C** ii) and iii). Thus, some sub-beams, i.e. not all sub-beams, may pass through the deflector 300, 235. Generally, compensating for the risk of collision of the sub-beams with the electrodes by slightly adjusting, for example decreasing and/or increasing the pitch between the electrodes is challenging if not impossible. Between any two electrode pairs, some sub-beams will have a shift in one direction in the beam grid and some other sub-beams in the a different direction for example towards the position of an electrode in a down beam deflector array, even an opposite direction (in the frame of reference in which the direction is being measured). In a less extreme case, the shift may be small enough to prevent collision with the electrodes, but then still the shift consumes a large part of the budget for beam position errors in general. The tolerance for compensating and/or correction such as other positional variations or perturbations, even errors such as incident beam position error, of the sub-beams in the beam grid is reduced and thus smaller and may even be insufficient for operation.

To reduce or account for these perturbations , additional corrective individual sub-beam deflections may be applied down beam of the deflector 300 to compensate for the sub-beam shifts. The paths of the sub-beams may consequently pass correctly through subsequent down-beam elements, such as the objective array, which are organized according to an intended beam grid for example adesired grid,. Such compensation may be may be achieved by a multipole deflector array (which may be referred to as an individual beamlet corrector (described further below). Such a multipole deflector array may be positioned below the deflector 300, 235. The multipole deflector array may be controlled to apply fine adjustment to the direction of a sub-beam trajectory. Thus fine adjustments o the directions of the sub-beam trajectories in the beam grid may be applied by the multipole deflector array. However, the corrective deflection to compensate the trajectory shift described above is typically a few hundred $\mu$rad, which is a large part of the maximum deflection range of a typical individual beamlet corrector grid. A large part of the budget for corrective deflections is consumed by the trajectory shift, which is unwanted. The corrective deflection leads to a shift in landing position of the sub-beams on the sample 208. Such a shift in the landing position can be up to a few hundred nm. The direction of such beams on incidence with sample position along the beam path of the multi-beam arrangement, have an angle with respect to the normal to a plane of the sample position; that is the sub-beams may have a non-zero angle of incidence. The angle of the sub-beam trajectory can typically be a few hundred $\mu$rad. Depending on the specifications of the assessment apparatus, for example in terms of details of image acquisition, such a large angle of incidence may be problematic.

It is known that deflectors in general may add aberrations to the deflected beam. The dominant aberration may be astigmatism. That is, the deflector has a focusing effect in the plane of deflection. This is because the side of the beam that is closest to a negatively charged electrode is slightly decelerated by that electrode. Subsequently the slightly less energetic charged particles (e.g. electrons) are slightly more sensitive to the deflecting force. The opposite is the case for the side of the charged particle beam closest to a positively charged electrode. The net effect is that the beam is focused. This effect can be minimised by placing the deflector 300 , around the intermediate foci 233 of the sub-beams (as shown in **FIG. 3**) for example as deflector or deflector array 235, so that the sub-beams, for example at least a dimension of the sub-beams, are very small in lateral size, such a diameter of the sub-beam cross-sections at this position in beam path of the intermediate foci; therefore the astigmatic aberration of the sub-beams is small. There may still be an residual astigmatic effect because the deflector 300 , 235 extends along the beam path. For example, only one of the slit arrays (in a stack of slit arrays) can be placed at the position of intermediate focus 233 along the beam path. The other two slit arrays of the deflector 300, 235 need to be placed some distance away from the intermediate focus plane. A strip array placed upbeam of the intermediate focus 233 (for example in a converging extent of the sub-beam path) may lead to a slight increase of the sub-beam divergence down-beam of the intermediate focus 233, in the direction of deflection for example relative to the path of the multi-beam arrangement.

Attempting to reduce, desirably minimize, the magnitude of the shift of the position of sub-beams within the beam grid (which may be the characteristic of the grid), the strip arrays are reduced desirably as much as possible so that the strip arrays are as thin as possible. That is the thickness of the strip arrays are reduced desirably the thickness is as small as possible. In an example embodiment, to limit the shift in position of a sub-beam within the beam grid to 5 $\mu$m, the layer thickness (i.e. the electrode depth) and spacing between the layers (i.e. the distance between adjacent strip arrays along the beam path) may be limited to about 50 $\mu$m (although the thickness and spacing may be limited to different values for different designs). However, this solution has only limited scope. The deflection caused by the electrodes is proportional to the layer thickness times the voltage on the electrodes. So a smaller thickness needs to be compensated by proportionally larger voltages to achieve the correct deflections. For example for electrode depths of between 30 to 100 $\mu$m high electric fields result (for example between 10 and 50 kV/mm, such as above 20 kV/mm).

This is undesirable for at least two reasons.

a. It is known from experience that for such high fields it is very challenging to avoid electrical breakthrough and electrical discharge ( or sparking). Breakthrough may damage elements of the charged particle apparatus participating in the discharge, for example the strip array. Such charged particle element especially comprise arrays of electrostatic elements such as strip array which may consist of delicate electrodes which may have dimensions of a micron. For example a strip array may, for example only, be 5 to 40 μm e.g. 15 μm thin and approximately 1 to 30 mm, desirably more than 5 e.g. 10 mm, long. Note a strip array too thin would have inadequate mechanical strength; a strip array that this too thick would require an undesirably increase in the electron beam pitch.

b. High electric fields cause the thin, electrically charged electrodes such as the long thin electrodes of the strip arrays to bow for example along the beam path such as between strip arrays and cross the beam grid between adjoining electrodes in the strip array. This is because the elongate electrodes are charged with alternating voltages, so that neighbouring elongate electrodes attract each other. Because, for most elongate electrodes attract adjoining electrodes asymmetrically with respect to a center of the beam grid, this electric attraction causes the elongate electrodes the bend one way. For example a left neighbor of an electrode in the strip array attracts more strongly than a right neighbor to the same electrode or vice versa. For example, from the material properties of silicon of which the elongate electrodes can be made, it may be estimated that this bending in an embodiment can deform or bow an elongate electrode with a deflection having a maximum at the midpoint along the length of the electrode for example as much as ten percent of the thickness of the electrode for example a 1 to 2 μm deflection . A bow of such magnitude may: impact mechanical stability; cause changes in the sub-beam deflections; and increase the likelihood for breakthrough (or discharge).

The present invention described in the aspects below may be beneficial in reducing or addressing at least one of the problems identified above.

In an embodiment, the charged particle optical device (as described in any of the above embodiments and variations) for projecting a plurality of beams of charged particles towards a sample position may be used. The plurality of beams may be the sub-beams 211, 212, 213 described above and are referred to interchangeably herein.

The charged particle optical device may comprise a beam limiting aperture array 225 in which are defined a plurality of apertures. The plurality of apertures are positioned so as to generate the grid of the plurality of beams. The beam limiting aperture array 225 may be integrated with, or directly adjacent to, the condenser lenses 231 as shown in FIG. 3. Although the beam limiting aperture array 225 could be incorporated into the condenser lenses, the beam limiting aperture array 225 could also be provided separate from the condenser lenses 231.

Additionally or alternatively, the charged particle optical device may comprise a plurality of strip arrays 390 positioned along the paths of the plurality of beams. In other words, the strip arrays can be positioned in different positions along the beam paths. Desirably, the strip arrays are stacked along the paths of the plurality of beams, i.e. with one strip array adjacent to another in the direction of the beam. The strip arrays 390 may be part of the deflector 300, 235 described above. Although the strip arrays 390 of the present invention are adapted as described below.

The strip arrays 390 extend across a path of the plurality of beams (as shown in FIG. 4) so as to operate on the charged particles that pass along the path between strips (i.e. elongate electrodes) of the respective strip array 390 to collimate the path of the passing beams. The orientation of the strips in the array of at least two different arrays along the beam path being different. In other words, at least one strip array has elongate electrodes (e.g. 301a in **FIG 8)** which are at a different orientation to the elongate electrodes (e.g. 301b in **FIG 8)** of another strip array. This means that the elongate electrodes of one strip array (which are substantially parallel to each other within the strip array) are not parallel with the elongate electrodes of another strip array (as shown by the different strip arrays 390a, 390, 390c at different orientations in **FIG. 8).**

As shown in the figures, it is generally intended for a single line or row of charged particle beams to pass between adjacent elongate electrodes of the strip array. This is preferable as it ensures that the row of sub-beams is deflected the desired amount. However, this is not a necessity, for example, the elongate electrodes 301 of a strip array 390 may be arranged so that multiple lines of beams could pass between adjacent electrodes 301. The present description focuses on a single line of beams passing through adjacent electrodes (or at least some of the adjacent electrodes), but the single line of beams could thus be replaced with multiple lines of beams.

At least one of the beam limiting aperture array 225 and the plurality of strip arrays 390 is configured to mitigate a characteristic of the grid that is induced by passage of the plurality of beams through the plurality of strip arrays 390. Thus, at least one of the beam limiting aperture array 225 and the plurality of strip arrays 390 may counter the characteristic, i.e. reduce the characteristic, potentially to substantially avoid unwanted deflections. Additionally or alternatively, at least one of the beam limiting aperture array 225 and the plurality of strip arrays 390 may be adapted to account for and/or cope with the characteristic, e.g. to reduce or avoid the impact associated with the characteristic. For example by reducing the likelihood, or avoiding, at least one of the charged particle beams colliding with one of the elongate electrodes 301 of one of the strip arrays 390. Thus, the beam limiting aperture array 225 and/or the plurality of strip arrays 390 are configured in such a way as to adapt a characteristic of the grid and/or account for a characteristic of the grid.

Embodiments of charged particle device 40 of at least a deflector 300, 235 may embody the invention in a number of aspects which are hereinafter disclosed. To aid clarity the different aspects are described separately. However, in embodiments of charged particle device 40 may comprise multiple aspects for example having one or more deflectors embodying one or more of the aspects.

In a first aspect, the charged particle optical device comprises the plurality of strip arrays 390 which are configured to mitigate the characteristic of the grid. The strip arrays 390 may be arranged as described in any of the embodiments above, for example as part of the deflector 300, except for the features specific to this aspect as described below.

The elongate electrodes (i.e. strips) of at least one of the plurality of strip arrays 390 is positioned based on shifted locations of the paths of the beams. This means that at least one of the strip arrays 390 is adjusted to account for the actual location of the sub-beams, rather than the desired (i.e. ideal) location of the sub-beams. For example, the pitch of the elongate electrodes 301 of the strip array 390 and/or the orientation of the elongate electrodes 301 of the strip array 390 may be selected based on the actual location of the sub-beams as they pass through the plurality of strip arrays 390 . This may allow more, if not all, of the sub-beams to avoid collision with the elongate electrodes 301, i.e. to pass through the slits defined by the strips. If all of the plurality of strip arrays 390 are positioned based on the shifted locations, this may allow more, if not all of the sub-beams to avoid collision when passing through the plurality of strip arrays 390. Ideally, the sub-beams trajectories can pass through the mid-points for example centers of their respective slits after appropriate adjustments of the pitch and rotation of the plurality of strip arrays 390.

In a configuration such as in FIG. 8 (without any pitch or rotational adjustment), the slits 302 defined by the strip arrays 390 align to the sub-beam positions when the pitch of the slits (i.e. the spacing between the slits) relates to the design pitch between the sub-beams. This is when the pitch of the slits fulfils a specific relationship, which may be expressed as $\sqrt{3}p/4$ , where $p$ is the design pitch between the sub-beams. $\sqrt{3}p/4$ is the pitch of the collimated beam mapped onto Cartesian coordinates. Such an arrangement that fulfills this relationship may be referred to as the standard configuration. The strip arrays shown in FIG 9C are arranged in the standard configuration. It is noted that the pitch of the slits is the distance from the center of one slit to the center of an adjacent slit. The pitch of the slits may be approximated by the pitch between electrodes on the same side of respective adjoining sub-beams, which may correspond to the pitch 320 between adjacent sub-beams.

Generally, a pitch of a slit for the passage therethrough of the beams defined in at least one of the strip arrays 390 may be smaller than a pitch of a slit for the passage therethrough of the beams defined in another one of the strip arrays 390 further down-beam. The pitch may be reduced by reduction of the slit width (e.g. by making adjacent electrodes and the corresponding facing surfaces closer together). Additionally or alternatively, the pitch may be reduced by reduction of the strip width (e.g. by making the elongate electrodes 301 thinner across the plane of the strip array 390). For example only, the pitch of the slits in one of the strip arrays may be reduced (compared to the standard configuration with the pitch of the slits of $\sqrt{3}p/4$ , where $p$ the design pitch corresponding to the desired pitch between the beams on landing, i.e. the collimated pitch e.g. at the sample position or the objective lens) by a factor which may be referred to as the remainder of the value (Q) from unitary, i.e. (1-Q).

Here the value (Q) is defined by relationship:

$$Q = (L + D)\theta/pN. \quad [\text{Equation 1}]$$

$L$ is the slit array thickness (i.e. the depth of the elongate electrodes shown by arrow 322 above). D is the spacing between the strip arrays (i.e. the distance between one strip array and an adjacent strip array, desirably in a direction along the beam path). $\theta$ is the inclination angle of the outermost sub-beam. The inclination angle of the sub-beam is the angle of the sub-beam on entry into to the strip array relative to a direction orthogonal to the plane of the sample position. N is the number of hexagonal rings of sub-beams in the grid for example around a centre of the grid (which would be two in the grid shown in FIG 9B for example, noting he central sub-beam at the center of the grid is excluded from the count). The pitch of one of the strip arrays further down-beam may be reduced by a pitch adjustment factor (1-Q/6). Additionally or alternatively, the pitch of one of the strip arrays further down-beam may be increased by a pitch adjustment factor of (1+Q/2).

Q is a perturbation away from the ideal. Effectively, Q is a measure of how fast the beam pitch changes over the typical vertical distance in the system, and therefore it quantifies how much the non-zero vertical height of the collimator leads to trajectory displacements. In other words, Q is the ratio of the change in beam pitch (e.g. increase in separation between two neighbouring beams) between adjoining slit arrays relative to the design pitch. The magnitude of the characteristic of the grid is proportional to Q. The factors (1-Q), (1-Q/6) and (1+Q/2) referred to above are representative of small corrections to the slit pitch based on the value of Q.

Desirably, the plurality of strip arrays comprises at least an up-beam strip array 390a, a middle strip array 390b and a down-beam strip array 390c. The strip arrays may each define slits for the passage therethrough of the plurality of beams. This is shown in at least i), ii) and iii) respectively of **FIG 9A** and **FIG 9D**. These figures of **FIG** 9A and **FIG 9D** show electrodes 301a of the up-beam strip array 390a, electrodes 301b of the middle strip array 390b, and electrodes 301c of the down-beam strip array 390c. As described herein, desirably each slit is defined between facing surfaces of adjacent elongate electrodes in a respective strip array.

A pitch of the slits as defined by the up-beam strip array 390a may be smaller than a pitch of the slits defined by the middle strip array 390b and/or the pitch of the slits defined by the down-beam strip array 390c. Additionally or alternatively, a pitch of the slits defined by the middle strip array 390b may be smaller than a pitch of the slits defined by the down-beam strip array 390c. For example only, compared to the standard configuration described above, the pitch of the slits of the up-beam strip array 390a may be reduced by a factor (1-Q); the pitch of the slits of the middle strip array 390b may be reduced by a factor (1-Q/6); the pitch of the slits of the down-beam strip array 390c may be increased by a factor of (1+Q/2).

Adjustment of the pitch of the slits of the strip arrays as described above can be beneficial in more closely matching the actual (i.e. shifted) sub-beam positions for example with the beam grid. Improved matching of the slit pitch of the strip arrays with the positions of the sub-beam trajectories within the beam grid, for example at different positions of the beam path of the multi-beam arrangement, reduces the likelihood of the sub-beams colliding with the elongate electrodes of the strip arrays. Reduced likelihood in collision of sub-beams with the electrode may be beneficial in freeing up budget and tolerance for other sub-beam aberrations such as beam misalignment within the grid derived from other sources. Further improvement in the alignment and/or positioning of the sub-beams within the beam grid may be achieved by adjusting the orientation of the strip arrays relative to other strip arrays for example of the deflector 300, 235 as described below. Adjusting the orientation between the strip arrays can be done in combination with, or separately from, the adjustments to the pitch as described above.

In an embodiment, the elongate electrodes 301 (i.e. strips) in a strip array 390 have a common orientation across the paths of the plurality of beams. In other words, the elongate electrodes 301 in a single strip array 390 may be oriented in the same direction for example in a common plane. Thus, the elongate electrodes 301 may all be substantially parallel to each other. Desirably the elongate electrodes 301 of the different strip arrays are parallel to each other in the beam path direction. In other words, the distance between adjacent strip arrays 390 is desirably substantially uniform across those strip arrays 390. The elongate electrodes 301 of different strip arrays may be parallel to each other but at different positions of the beam path of the grid.

The common orientation of the plurality of strip arrays 390 (i.e. the orientation of the strips within each of the strip arrays) may have a rotational symmetry with a geometric angular displacement between the orientations of the strip arrays. In other words, the strips of one strip array may have a first orientation, and the strips of another strip array may have a second orientation, and the first orientation may be rotated relative to the second orientation depending on the geometric angular displacement. Desirably the geometric angular displacement is substantially 60, 90 or 120 degrees. For example, if the strip arrays 390 are being used with a substantially hexagonal grid, the geometric angular displacement may be substantially 60 or 120 degrees (as shown in FIG 8). For example, if the strip arrays 390 are being used with a substantially rectangular or square grid, the geometric angular displacement may be substantially 90 degrees. Desirably, the angular displacement between at least two of arrays is perturbed to have an angular displacement different from the geometric angular displacement. The perturbed angular displacement may be greater than the geometric angular displacement.

Desirably the angle between the orientation of the up-beam strip array 390a and the orientation of the middle strip array 390b is other than the rotational angle of symmetry for example substantially 60 degrees. In other words, the angle between the elongate electrodes 301a of the up-beam strip array 390a and the elongate electrodes 301b of the middle strip array 390b is desirably other than 60 degrees, even for the hexagonal grid. Desirably, the angle between the orientation of the up-beam strip array 390a and the orientation of the middle strip array 390b is greater than the rotational angle of symmetry for example substantially 60 degrees. Desirably, the strips of the middle array 390b are rotated by an angle of $Q/2\sqrt{3}$ (which is generally a small angle in radians) compared to the standard configuration (for example, compared to the geometric angular displacement which may be substantially 60 degrees). Desirably, the rotational angle (i.e. $Q/2\sqrt{3}$) is a slight variation or perturbation determined to be proportional to the magnitude of the effect we want to mitigate i.e. the shift of the beam position in the grid; the value also accounts for the mapping of the six fold geometry to Cartesian coordinates and therefore the angular rotation is proportional to the perturbation.

Additionally or alternatively, the angle between the orientation of the middle strip array 390b and the orientation of the down-beam strip array 390c is other than the rotational angle of symmetry for example substantially 60 degrees. In other words, the angle between the elongate electrodes 301b of the middle strip array 390b and the elongate electrodes 301c of the down-beam strip array 390c is desirably other than 60 degrees, even for the hexagonal grid. Desirably, the angle between the orientation of the middle strip array 390b and the orientation of the down-beam strip array 390c is greater than substantially the rotational angle of symmetry for example 60 degrees. Desirably, the strips of the down-beam array are rotated by an angle of $-Q/2\sqrt{3}$ compared to the standard configuration (for example, compared to the geometric angular displacement which may be substantially 60 degrees). Desirably, the rotational angle (i.e. $-Q/2\sqrt{3}$) is a slight variation or perturbation determined to be proportional to the magnitude of the effect we want to mitigate i.e. the shift of the beam position in the grid; the value also accounts for the mapping of the six fold geometry to Cartesian coordinates and therefore the angular rotation is proportional to the perturbation. In this case, the rotational angle is

$-Q/2\sqrt{3}$ meaning that it is in a rotationally opposite direction to the rotational angle $Q/2\sqrt{3}$ described above.

(Note that in this arrangement the rotational angle of the different strip arrays is with respect to a middle electrode with the up-beam and down beam strip arrays having angular displacements relative to the middle electrode in opposite rotational directions, this is a choice or convention. The inventor envisages that other frames of references are feasible, for example with respect to the up-beam strip array or the down-beam strip array and the angular displacement of the strip arrays with respect to the reference strip array may be in the same rotational direction).

In a desirable combination of pitch and orientation of the arrays the center of the plurality of strip arrays (e.g.. the center of the middle slit array) is positioned at a position along the beam path of the grid in charged particle device such that the beam pitch fulfills one or more conditions. At the position along the beam path of the gird, the beam pitch is equal to the design pitch $p$ , and

1. the pitch of the slits of the up-beam strip array 390a are reduced by a factor $1-Q$ compared to the standard configuration;
2. the pitch of the slits of the middle strip array 390b are reduced by a factor $1-Q/6$ and this array is rotated by an angle $Q/2\sqrt{3}$ compared to the standard configuration (so that the orientation of the middle strip array 390b is closer in alignment to the up-beam strip array 390a); and
3. the pitch of the slits of the down-beam slit array 390c is increased by a factor $1+Q/2$ and this array is rotated by an angle $-Q/2\sqrt{3}$ compared to the standard configuration (so that the orientation of the down-beam strip 390c array is further in alignment from the up-beam strip array 390a).

The design pitch is the beam pitch of the collimated grid down beam of the collimator, through objective lenses (including control lenses, which may otherwise be part of objective lenses) and the grid at the sample position; the above text considers the adjustments when accounting for the perturbation to the slits so that they mitigate the otherwise consequential shift of the beam positions in the grid.

In such a preferred combination, the slits may be centered on the shifted sub-beam positions. This can resolve problems described above because it mitigates the risk for sub-beam collision with the elongate electrodes of the strip arrays which means that the sub-beams should pass through the slits of the strip arrays of the detector 300, 235. That is the trajectories of the sub-beam should not collide with the elongate electrodes 301 of the strip arrays 390 as shown in FIG 9D. Additionally, it frees up budget and tolerance for other causes of sub beam aberration such as sub-beam misalignments. However, it does not resolve some other aberrations of the sub-beams, such as sub-beam shifts which are visible from the shape of the grid downbeam of the plurality of strip arrays (as shown in iii) of **FIG 9B)** . FIG 9B shows the beam grid at different positions along the beam path of the beam grid for example at positions of the strip arrays along the beam path, The beam grid at the different positions have a different shapes. The shape of the beam grid changes from entry of the beam grid to the most up-beam strip array (as shown in i) of **FIG 9B)** to the position of the down beam strip arrays along the beam path of the grid (as shown in in ii) and iii) of **FIG 9B** respectively).

Additionally, a minor complication is that the strip array rotations above result in a configuration where the strip arrays are not oriented at exactly 60 degrees with respect to each other. This can result in a residual, non-zero sub-beam inclination at the exit of the plurality of strip arrays, i.e. the plurality of strip arrays does not perfectly collimate the sub-beams. However, the residual sub-beam inclination is small, and should be $Q^2\theta/6$ for the worst-case sub-beam, which is typically below 10 urad. Thus, this added imperfection is small compared to the corrective deflection needed to compensate the sub-beam shifts.

The first aspect may be adapted to include at least one additional strip array. The at least one additional strip array could be provided above the up-beam strip array 390a, between the up-beam strip array 390a and middle strip array 390b, between the middle strip array 390b and down-beam strip array 390c and/or below the down-beam strip array 390c. At least two of the strip arrays may be provided as pairs, as will be described in relation to the second aspect below.

Advantages of the first aspect may include mitigation of sub-beams colliding with the strip arrays (which might lead to non-functional sub-beams), or for less extreme cases, increasing the tolerance of the collimator for external causes of beam position errors.

Although it may be preferable to provide a difference between the orientations of different strip arrays, e.g. a non-zero angle between the strips of different strip arrays, it is noted that there are some instances in which at least two of the strip arrays may desirably be provided at the same orientation, i.e. wherein the angle between the elongate electrodes 301 of the different strip arrays 390 is substantially zero. This may be the case when at least two strip arrays are provided as pairs, for example as described in further detail below in relation to the second aspect.

In a second aspect, the charged particle optical device comprises the plurality of strips arrays 390 which are configured to mitigate the characteristic of the grid. The strip arrays may be arranged as described in any of the embodiments above, for example as part of the deflector 300, except for the features specific to this aspect as described below.

As described above, the characteristic of the grid induced by propagation of the plurality of beams through the plurality of strip arrays 390 is the difference between the actual position of each of the beams in the grid and the desired position of that beam in the grid. Thus, the plurality of strip arrays 390 may be configured to mitigate such a characteristic. In the second aspect, the plurality of strip arrays may be configured to counter the characteristic, i.e. to reduce the characteristic.

The strip arrays may be oriented as described in relation to **FIGs 10A-10D.** As shown in **FIG** 10A, the plurality of strip arrays 390 may be a series of strip arrays for example including six strip arrays which are labelled 390a, 390b, 390c, 390d, 390e and 390f in **FIG 10A** from the uppermost strip array (i.e. the strip array which is most up-beam) to the lowermost strip array (i.e. the strip array which is most down-beam) respectively. For ease of reference only, the strip arrays 390a, 390b, 390c, 390d, 390e and 390f may be labelled as first, second, third, fourth, fifth and sixth strip arrays, and are positioned in with the first strip array 390a as the uppermost (or down beam most) strip array to the the sixth strip array 390f in number descending order going downbeam as shown in **FIG** 10A. The down beam most strip array is thus the sixths strip array 390f.

As shown in **FIG 10D,** at least of two of the strip arrays extend in the same orientation in a plane across the direction of the paths of the beams. Thus, at least two of the strip arrays can be provided with electrodes which are parallel to each other. More specifically in **FIG 10D,** the electrodes 301a in the first strip array 390a (shown in i)) are at the same orientation as the electrodes 301f in the sixth strip array 390f (shown in level vi)); the electrodes 301b in the second strip array 390b (shown in level ii)) are at the same orientation as the electrodes 301e in fifth strip array 390e (shown in level v)); the electrodes 301c in the third strip array 390c (shown in level iii)) are at the same orientation as the electrodes 301d in the fourth strip array 390d (shown in level iv)). Desirably, as shown in **FIGs 10C** and **10D,** all the strip arrays extend in the same orientation as another of the strip arrays. This means that each of the strip arrays has another corresponding strip array which is oriented in the same way, i.e. has electrodes which are parallel. These corresponding strip arrays (e.g. the first strip array 390a and the sixth strip array 390f) may be referred to as similarly orientated strip arrays or parallel strip arrays. In operation of an embodiment, a plane of intermediate focus may be located between corresponding strip arrays that are similarly orientated.

More generally, at least two of the plurality of strip arrays are provided in pairs, with each pair comprising two strip arrays extending in the same orientation in the plane. This means that at least one of the strip arrays has another corresponding strip array which is oriented in the same way, i.e. has elongate electrodes which are substantially parallel. As shown in **FIG 10D,** the first strip array 390a and the sixth strip array 390f may be a pair, the second strip array 390b and the fifth strip array 390e may be a pair, and the third strip array 390c and the fourth strip array 390d may be a pair. Each pair of strip arrays may be referred to as similarly orientated strip arrays or parallel strip arrays. All the strip arrays 390 maybe provided in pairs, i.e. with each strip array having a corresponding strip array with the same orientation. In operation of an embodiment, the first strip array 390a, the second strip array 390b and the third strip array 390c may be displaced in the same direction along the beam path of the beam grid relative to the plane of intermediate focus; the first fourth array 390d, the fifth strip array 390b and the sixth strip array 390c may be displaced in the opposite direction along the beam path of the beam grid relative to the plane of intermediate focus relative to any of the first, second and third strip arrays 390d, 390e, 390f.

Desirably two strip arrays which are provided with electrodes at the same orientation (e.g. 390a and 390f) are configured to deflect the plurality of beams so that the net deflection on the beams is distributed between each of these strip arrays. This means that the deflection provided by the strip arrays which are parallel to each other can split the deflection between the separate layers or strip array. For example, the deflection in a direction perpendicular to the electrodes 301a can be split between the first strip array 390a and the sixth strip array 390f. In an embodiment deflection of a sub-beam trajectory in a direction perpendicular of the electrodes of one of the strip arrays, that is displaced in a direction relative to the plane of intermediate

In particular, providing a deflector with six strip arrays (for example as in FIGs 10A-10D) means that the deflections can be distributed over the additional layers with half strength compared to providing three strip arrays (for example as in FIGs 9A-9D) with full strength. Because each layer only needs to have half the deflection strength, the voltages on (or potential differences applied to) the elongate electrodes only need to be half as high as strip arrays comprising three layers of strip array. This significantly reduces complications relating to high voltages for example in having high potential differences applied between components which would otherwise increase the risk of unwanted discharge for example through electron creep over insulating surfaces that may support and space strip arrays apart from each other.

By appropriately choosing the order of the orientations of the strip arrays, the characteristic (i.e. trajectory shift effect) can be reduced or even cancelled out. This may be beneficial in helping to address some, if not all the problems mentioned above.

As shown in **FIG 10D,** similarly orientated arrays may have an up-beam strip array (e.g. 390a) and a down-beam strip array (e.g. 390f) along the beam path. In other words, each pair may have an up-beam and a down-beam strip array. Up-beam and down-beam are referred to with respect to the beam path and thus, up-beam means more up-beam, i.e. closer to the source position, and down-beam means more down-beam, i.e. closer to the sample position. Thus, the strip arrays which are provided with another corresponding strip array (with a similar/the same orientation) will have an up-beam strip array and a down-beam strip array. Desirably all the up-beam strip arrays 390a, 390b, 390c are positioned up-beam of their corresponding down-beam strip arrays 390d, 390e, 390f respectively. In other words, each of the strip array pairs has one of each pair above a certain point, and the other of each pair below a certain point. In an embodiment the certain point may be at or close to the plane of intermediate focus. In this way, the up-beam strip arrays can be grouped together, and would be provided together. In this way, the down-beam strip arrays can be grouped together, and would be provided together. In other words, there may be a mid-plane 391 between the strip arrays along the beam path as shown in **FIGs 10A-10D.** The mid plane 391 may correspond to or be approximate to the plane of intermediate focus, but this need not be the case. The plane of intermediate focus may even up beam or down beam of the deflector 300, 235. There may be the same number of strip arrays up-beam of the mid-plane 391 as there are down-beam of the mid-plane 391. When the strip arrays are all provided in pairs, there may be the same number of strip arrays with the same orientations above the mid-plane 391 as below the mid-plane 391.

The up-beam strip arrays 390a, 390b, 390c may be positioned up-beam of the intermediate focus plane 232 of the plurality of beams. Thus, all of the up-beam strip arrays of each pair may be up-beam of the intermediate focus plane 232. Additionally or alternatively, the down-beam strip arrays 390d, 390e, 390f are positioned down-beam of the intermediate focus plane 232 of the plurality of beams. Thus, all of the down-beam strip arrays 390d, 390e, 390f of each pair may be down-beam of the intermediate focus plane 232. In this case, the intermediate focus plane 232 may be the same as the mid-plane 391described above. It is not essential for the cancellation of the characteristic that the mid-plane 391 is an intermediate focus plane 232. However, when the mid-plane 391 is the intermediate focus plane 232, this can be beneficial in minimizing intra-beam aberrations due to the plurality of strip arrays.

The up-beam strip arrays 390a, 390b, 390c can be provided in a first order and the down-beam strip arrays can be provided in a second order 390d, 390e, 390f. Any appropriate order may be used, as discussed further below. However, in a preferred configuration, the second order is a reverse of the first order as shown in **FIGs 10A-D.** For example only, electrodes 301a and 301f may be considered to have an orientation A, electrodes 301b and 301e may be considered to have an orientation B, and electrodes 301c and 301d may be considered to have an orientation C. The orientation of the strip arrays as shown in **FIGs 10A-D** are provided in the following order A-B-C-C-B-A. This configuration with equally spaced strip arrays of equal thickness along the beam path may be particularly beneficial for reducing or cancelling the characteristic. Equally spaced generally means that the same distance is provided between each adjacent strip array in the direction along the beam path. Desirably the intermediate focus is at the midpoint of the series of strip arrays along the beam path of the beam grid so that there may be a similar displacement along the beam path of the grid relative to the plane of intermediate focus from strip arrays having similar orientations.

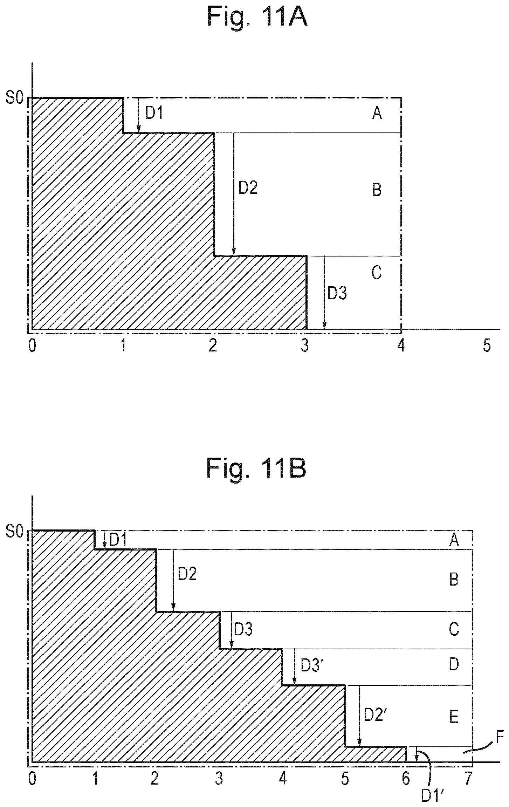

To explain why this configuration may cancel trajectory shifts, we can examine how the trajectory shift may be calculated from the deflections in each layer. **FIG. 11A** shows a graphical representation of the trajectory shift for one particular sub-beam in one particular direction (say, x i.e. in a direction of the x-axis, e.g. orthogonal to the collimated beam path) in a standard three-layer configuration described above in relation to **FIG 8.** That is the graph in FIG 11A shows the inclination angle of the path of the beam as function of the vertical distance, i.e. in the direction of the collimated beam. The inclination angle of the path of the beam on reaching the deflector is S0. Again approximating each deflection in each individual layer by an instantaneous change in the sub-beam trajectory slope, the slope as a function of traveled distance be stepped; that is the slope as a function of displacement along the beam of the grid is represented in **FIG. 11A.** In the FIG. 11A, D1 is Deflection 1, the deflection in a first slit array for example at 1 or layer 1; D2 is Deflection 2, the deflection in a second slit array for example at 2 or layer 2; and D3 is deflection 3, the deflection in a third slit array for example at 3 or layer 3. The slope appears as a staircase, with a step at the center of each strip array layer (for example represented by the positions along the x-axis of the graph at 1, 2 and 3. The x axis is in units of displacement along a direction parallel with the collimated beam path. The origin along the x axis corresponds to one unit up beam of the most up beam slit array, desirably the midpoint of the moist up-beam strip array. The extra integer, 4, is one unit down beam of the most down beam strip array desirably relative to the midpoint of the most down beam strip array. The extent of the sub-beam path through deflector for example along the x-axis. The sub-beam path shown is the sum of the electrode depth (or layer thickness; L) and the separation between slit arrays (or is the spacing between the strip arrays; D); that is the distance of the sub-beam path through one of the slit arrays of the deflector is L+D, or more specifically the distance between the midpoints of adjacent slit arrays, i.e. in the direction of the collimated beam path. The origin along the x-axis, for example at x=0, is chosen at one (1) layer thickness above the plurality of strip arrays.

By design, the three deflections add up to be equal to the initial slope, and hence the slope is zeroed at layer 3, indicative of a collimated beam path down beam of the deflector 300, 235:

$$\text{Deflection 1} + \text{Deflection 2} + \text{Deflection 3} = \text{Initial slope} \quad [\text{Equation 2}]$$

Now, the lateral shift is the integral of the slope over distance, i.e. it is proportional to the shaded surface area under the curve. An alternative way to calculate this area is to consider an area shown in FIG. 11A which is shaded under the stepped slope; note that the area of the box with the dashed line represents the lateral shift of the beam if is not deflected by the deflector:

$$\text{Lateral shift} = \text{box with dashed line} - \text{area A} - \text{area B} - \text{area C} = 4x \text{ Initial slope} -$$

$$[3x \ (\text{Deflection 1}) - 2x(\text{Deflection 2}) - 1x \ (\text{Deflection 3})]*(L+D) \quad [\text{Equation 3}]$$

Combining the equations 2 and 3 shows that the shift is a combination of the three deflections, which is different for each sub-beam, which results in a complicated pattern of shifts.
In contrast, we now consider the proposed collimator. In this case, the collimator layers only have half the strength, so that:

$$\text{Deflection 1} + \text{Deflection 2} + \text{Deflection 3} = \tfrac{1}{2}*(\text{Initial slope}) \quad [\text{Equation 4}]$$

The trajectory shift is proportional to the shaded area under the curve. Applying the same method as above to calculate this area, we get:

$$\text{Trajectory shift} = \text{box with dashed line} - \text{area A} - \text{area B} - \text{area C} - \text{area D} - \text{area E}$$

$$- \text{area F} = 7x \text{ Initial slope} - [7/2 \ x \ (\text{Deflection 1}) - 7/2 \ x \ (\text{Deflection 2}) - 7/2 \ x$$

$$(\text{Deflection 3})]*(L+D) \quad [\text{Equation 5}]$$

Where L is the slit array thickness (i.e. the depth of the elongate electrodes shown by arrow 322 above) and D is the spacing between the strip arrays or, with respect to a sub-beam path, between electrodes of adjacent strip arrays along the sub-beam path.
Combining equations 4 and 5 now gives:

$$\text{Trajectory shift} = \text{Initial slope} \ x \ 7/2 \ (L+D) \quad [\text{Equation 6}]$$

The trajectory shift calculated in equation 6 is exactly the same shift as if the sub-beam freely traveled a distance 7/2 (L+D) without the plurality of strip arrays present, i.e. the shift it would have at the midplane of the plurality of strip arrays if the plurality of strip arrays would be switched off. Note that this argument holds generally for each sub-beam and also for both the x- and y-direction. Therefore, if the sub-beams are focused into a grid of the desired pitch, and the plurality of strip arrays are placed symmetrically around the intermediate focus plane 232 (or more generally, if the sub-beams are directed to positions forming a regular hexagonal grid in the midplane of the plurality of strip arrays), the sub-beams will leave the plurality of strip arrays in this same grid (as shown by the grid on entry to the plurality of strip arrays in i) of **FIG 10B** and on leaving the plurality of strip arrays in vi) of **FIG 10B).** In other words, the proposed six-layer strip arrays of the second aspect should lead to zero trajectory shift. This is indicated in **FIG 10A vi)** by the actual beam (the solid arrow) being aligned with the desired beam (the dashed arrow) on exiting the plurality of strip arrays 390. It will be noted that each intersection of the lines of the beam grid in **FIG. 10B** corresponds to the position of a sub-beam in the beam grid.
Although the sub-beam shift may be exactly canceled at the exit of the plurality of strip arrays 390, shifts in the beam grid (i.e. non-zero shifts) at the intermediate planes. To prevent possible collisions of the beam trajectories with the strip arrays and/or to reduce a significant part of the sub-beam position error budget being used to account for this, adjustments of the pitch and rotation of the slit arrays may be applied. For example, the variations in the pitch and/or orientation described above in relation to the first aspect may be applied to the strip arrays of the second aspect.
In further detail, it can be shown that the slit positions and orientations are adjusted to the sub-beam trajectory shifts throughout the arrays if:

> **1.** The vertical center of the plurality of slit arrays (i.e. the mid-plane 391) is positioned at the height in the system where the beam pitch is equal to the design pitch;
> **2.** The pitch of the first strip array 390a is reduced by a factor 1-5$Q$/2 compared to the standard configuration;
> **3.** The pitch of the second strip array 390b is reduced by a factor 1-19$Q$/12 and this array is rotated by an angle $Q$/4√3 compared to the standard configuration;
> **4.** The pitch of the third strip array 390c is reduced by a factor 1-3$Q$/4 and this array is rotated by an angle -$Q$/4√3 compared to the standard configuration;
> **5.** The pitch of the fourth strip array 390d is reduced by a factor 1-$Q$/4 and this array is rotated by an angle -$Q$/4√3 compared to the standard configuration;
> **6.** The pitch of the fifth strip array 390e is reduced by a factor 1-$Q$/12 and this array is rotated by an angle $Q$/4V3 compared to the standard configuration.

The sixth strip array 390f may be aligned with the ideal beam grid, although this is not a requirement.

The factors relating to Q are as described above. In the present aspect, at least some of the factors are smaller because the correction of the deflector is distributed over more i.e. twice the number of, strip arrays. The angular values show that the angular perturbation is proportionate to the perturbation. Additionally, the numerical factor mapping between the coordinate systems of different frames of reference, i.e. from sixfold to a caretesian coordinate system.

As before, the (mild) price of making these adjustments is that it causes a non-zero residual collimation error. However, this residual sub-beam inclination is $Q^2\theta$/12 for the worst-case sub-beam (i.e. one half of the value applying to the 3-layer plurality of strip arrays), which is typically below 5 μrad. So this added imperfection is small and easily corrected by an multipole deflector.

A benefit of the six-layer strip arrays 390 proposed here is that some sub-beam aberrations such as beam misalignment and shift, and in particular the astigmatism which may otherwise be introduced, are compensated. This is because in the ideal design, three pairs of substantially equal deflectors are each placed symmetrically around the sub-beam focus. The up-beam strip array of the pair is placed in the converging part of the sub-beam relative to the plane of intermediate focus, and thereby causes an increase, which may be slight, of the divergence of the beam trajectory (i.e. after or down beam the focal point or plane of intermediate focus ). The down beam strip array, however, is placed in a diverging part of the beam trajectory, and therefore causes a slight decrease of the sub-beam divergence of the beam trajectory by the same amount. Hence, at least to first order, the astigmatism aberrations induced of both deflectors substantially counteract and desirably cancel.

Although the configuration is described above with the strip arrays in the order A-B-C-C-B-A as described, it is not a necessity that this specific order is used. For example, the first order and the second order could be the same, e.g. A-B-C-A-B-C. In this case, the configuration may not fully counter the characteristic, but may still be beneficial in mitigating the characteristic. Such an arrangement at least permits application of potential differences of half the magnitude.

Although the above embodiment describes that six strip arrays are used, it will be understood that additional strip arrays may also be provided, i.e. the plurality of strip arrays may include more than six strip arrays. Any additional strip arrays could be provided above or below any of the first to sixth strip arrays described above, desirably as additional pairs of strip arrays with a strip array up beam and down beam of the mid plane 391 of the deflector or otherwise an additional strip array up beam or down beam of the midplane 391. Thus additional strip arrays may be provided as additional strip array pairs.

Alternatively, fewer than six strip arrays may be provided. For example, the plurality of strip arrays may comprise five strip arrays or four strip arrays. If five strip arrays are provided, the middle strip array may be provided with electrodes with a greater depth, desirably double the depth of the electrodes of the other strip arrays. The electrode with greater depth may desirably be positioned in the middle of the stack of strip arrays, and/or at the intermediate focus. Thus, the electrode with greater depth could replace the third strip array 390c and fourth strip array 390d described above, and may essentially provide a strip array which corresponds to both the third and fourth strip array being integral with each other. If four strip arrays are provided, they may desirably be provided in two pairs. Four strip arrays may be particularly useful for a rectangular or square arrangement of sub-beams, that is a beam grid with a four-fold symmetry..

Although it is described above in relation to **FIG** 10A that all of the strip arrays are provided in pairs, this is not a necessity. Some but not all of the strip arrays may be provided in pairs. For example only, an electrode with a greater depth could be provided (as mentioned above) instead of a pair. Furthermore, it may be preferable that there are an even number of strip arrays, although this is not a necessity as is clear from the variations described herein.

Advantages of the second aspect can include distribution of collimation over six rather than three strip array layers, giving the opportunity to lower the required voltages in each layer, thereby reducing the challenge of electric breakdown and/or reducing the challenge to develop an electrical and mechanical design in which breakdown is prevented. Additionally, the second aspect is beneficial in reducing electrostatic bow of the elongate electrodes of the strip arrays, and associated problems such as uncontrolled electric breakdown, mechanical instability, and electro-optic impact on sub-beam deflections.

Other advantages may include reduction of the corrective deflections required from the subsequent multipole deflector array, and/or avoiding non-telecentric electron beam and beam landing position error on the wafer, both of which may affect resolution and contrast, and/or reducing residual collimator astigmatism, which may affect resolution.

In a third aspect, the charged particle optical device comprises the beam limiting aperture array 225 which is configured to mitigate the characteristic of the grid. The beam limiting aperture 225 may be used as an alternative to, or in addition to, the plurality of strip arrays 390 used in the first and/or second aspect as described above.

As described above, the ideal grid is the desired location of the sub-beams at the sample position. It was described above that the desired grid may be a scaled version of the standard grid, so that the sub-beams when projected along their respective desired trajectories, arrive at the sample position in the ideal grid. In the above aspects, the desired grid and the ideal grid are a standard grid. In this embodiment, the desired grid is selected to account for the variations, perturbations, aberrations or distortions in the position of at least one of the plurality of beams which are introduced by the strip array. Thus, although the ideal grid may still be the standard grid, the desired grid may be adapted to introduce a change in the position of at least one sub-beam depending on variations, perturbations, aberrations or distortions in the position of at least one of the plurality of beams.

In this embodiment, the characteristic of the grid induced by propagation of the plurality of beams through the plurality of strip arrays may be the difference between the actual position of each of the beams in the grid and the desired position of that beam in the grid; such a difference from the desired position may be referred to as a perturbation of the beam path in the beam grid. Thus, the beam limiting aperture array 225 may be used to account for the difference in the position of each beam compared to the desired position of the beam, for example in the beam grid at a position along the beam path if the beam grid. The difference in position may be known and may depend on the specific configuration of the strip arrays. For example, rectangular or hexagonal grids may lead to different position deviations, and a mirrored hexagonal arrangement may lead to mirrored position deviations.

As shown in FIG. 3, the beam limiting aperture array 225 is positioned above various other components which may be part of the charged particle optical device. The beam limiting aperture array 225 is positioned up-beam, i.e. closer to the source 201 than, the plurality of strip arrays. The beam limiting aperture array 225 can be used to generate the grid of sub-beams, i.e. to form the sub-beams 211, 212, 213 (or primary beams) from the beam (i.e. the primary charged particle beam) emitted by the source, or source beam. As the source 201 is effectively a point, the path of the primary beam from the source 201 to the beam limiting aperture array 225 is diverging. Thus, during operation the beam limiting aperture array 225 can generate the sub-beams 211, 212, 213 which then travel along the beam paths 220 through the plurality of strip arrays towards the sample 208 (or sample position).

The beam limiting aperture array 225 may generate the sub-beams using apertures through the beam limiting aperture array 225. The beam limiting aperture array has a body which may be planar. The beam limiting aperture array may be a substrate for example a plate. Specifically, in the beam limiting aperture array 225 are defined apertures positioned so as to generate the grid of the plurality of beams. The apertures are through-holes through the body, for example between opposing sides of the body e.g. as the plate. Desirably, the plurality of beams are generated along divergent beam paths from the diverging beam emitted by a source 201, as shown in FIG. 3. As shown in FIG. 3, the beam limiting aperture array 225 may be part of the array of condenser lenses 231. Thus, the beam limiting aperture array may be integrated with, or directly adjacent to, the array of condenser lenses 231. The array of condenser lenses 231 may be configured to focus the beams at respective intermediate foci 233.

In arrangements of aspects 1 and 2, the apertures in the beam limiting aperture array have a pattern, for example a two dimensional pattern or array, corresponding to the symmetry of the beam grid that the beam limiting aperture array is intended to generate from the source beam. For example the pattern of apertures may be of six fold symmetry, that is a regular hexagonal array.

The beam limiting aperture array 225 of the present embodiment of the third aspect is configured to provide the plurality of beams in the grid in a distorted arrangement. The distorted pattern may include a variety of forms, for example, an asymmetric pattern or a skewed pattern. The distorted grid may be provided as a non-regular grid, in which the position of at least one of the plurality of beams in the grid is not provided as part of a pattern, for example, which is offset from a position which would otherwise define a pattern. The grid may effectively be stretched. It is to be understood that the distortion of the grid can be defined as the relative difference of the beam positions in the beam grid between the positions of the sub-beams: when generated by the beam limiting aperture array; and when incident on the sample/sample position (that is the pattern of the sub-beams in the positions of the beam path on beam grid generation and the sample position, e.g. incidence on a sample surface). In an embodiment, ideally, the sub-beams are provided in a regular pattern or array when incident on the sample 208/sample position. (Note in some embodiments, there are benefits for the beam grid to be intentionally distorted, see for example PCT/EP2021/077305 filed 4 October and EP 3020062 A1, for which the beam grid is distorted to enable continuous scanning over a sample surface is hereby by incorporated by reference). Desirably the characteristic of the grid is a distortion in the symmetry of a pattern of the grid, desirably for which the distorted arrangement is configured to compensate.

The apertures defined in the beam limiting aperture array 225 may have the distorted arrangement in which the apertures are arranged in at least two lines having different orientations, wherein the at least two lines having an aperture pitch that differs, desirably the aperture pitch of at least two lines are similar, and/or the differing orientations are mutually rotationally asymmetrical about an origin of the beam grid desirably at least two of the orientations being rotationally symmetrical about the origin. In other words, the apertures may be positioned in the beam limiting aperture array as described herein, in order to arrive as the desired grid.

The solution of the third aspect comprises altering the layout or aperture pattern, desirably slightly, of the beam limiting aperture array 225 compared to using a regular aperture array; that is the pattern of the apertures in the beam limiting aperture array is perturbed. Consequently the beam grid incident on the deflector 235, 300 may have the opposite deviations (or perturbations) from the desired trajectories than the aberrations, misalignments or shifts of the beam trajectory within the beam grid added (or introduced) by the propagation of the sub-beams along the beam paths through the plurality of strip arrays 390. In other words, compared to a desired trajectory of a beam, the perturbations introduced by the beam limiting aperture array 225 may be opposite in direction but the same in magnitude as an aberration, misalignment or shift of the beam trajectory within the beam grid introduced by the propagation of the sub-beam through the plurality of strip arrays 390. In this way, characteristics induced in the beams by their trajectory through the plurality of strip arrays can be pre-compensated. This is indicated in **FIG** 12A by the offset between the actual beam (solid arrow) and the desired beam path (dashed arrow) in i) on entering the plurality of strip arrays 390, and is also shown in i) of **FIG 12B** wherein the grid is an asymmetric hexagonal arrangement rather than a standard hexagonal arrangement. The net result is that the paths of the sub-beams down beam of the deflector 235, 300 (e.g. the paths of the sub-beams on leaving the most down-beam of the plurality of strip arrays) are arranged in a desired grid (e.g. the standard grid for example of six fold symmetry, such as an intended hexagonal grid). Such a desired grid may have the beam trajectories positioned ideally within the grid, for example, with zero position deviation, or at least closer to the desired grid than the beams would otherwise be. This is indicated in **FIG 12A** by the alignment between the actual beam (solid arrow) and the desired trajectory (dashed arrow) in iii) on exiting the plurality of strip arrays 390. The preferred grid is also shown in iii) of **FIG 12B** wherein the grid is provided in a standard hexagonal arrangement. Each intersection of the lines of the beam grid in **FIG. 12B** corresponds to the position of a sub-beam in the beam grid.

The shifts in incident sub-beam position in the beam grid ($\delta x,\ \delta y$), for example in a frame of reference of orthogonal axes, which result in zero net shift at the end of the collimator, are:

$$\delta x\ =\ -3^{-1/2}Qy_0\ [\text{Equation 7}]\ \text{and}\ \delta y\ =\ -3^{-1/2}Qx_0\ [\text{Equation 8}]$$

where ($x_0,\ y_0$) are the coordinates of the position of a sub-beam in the desired hexagonal grid, and

$$Q = (L + D)\theta/pN$$

where $L$ the slit array thickness; $D$ is the spacing between the strip arrays; 0 is the inclination angle of the outermost sub-beam; $N$ is the number of hexagonal rings of sub-beams in the grid; $p$ is the design sub-beam pitch.

Because the charged particle sub-beam grid at the entrance of the plurality of strip arrays 390 is simply a scaled version of the electron sub-beam grid as it exits the condenser, the equations 7 and 8 also gives the modification of the aperture pattern of the beam limiting aperture array 225. The $\delta x,\ \delta y$ equations represent a slight skew of the hexagonal grid in both the x and y direction. In reality, Q is on the order of 0.001, so that the shifts are tiny compared to the full scale of the sub-beam grid. Locally, however, the shifts are significant compared to the size of the electrode structures (slit bars in the plurality of strip arrays, or apertures in the beam limiting aperture array 225). Locally, the aperture placements in the beam limiting aperture array 225 differ by almost an aperture diameter from the unmodified positions. The aperture diameter may be approximately 15 $\mu$m or less, e.g. 2 to 10 $\mu$m, desirably 4 to 8 $\mu$m. On the other hand, at any position in the beam limiting aperture array 225, the beam grid remains substantially a perfect hexagonal grid. The variation in position of the apertures are perturbations such that the hexagonal pattern of the aperture array can be considered substantially a perfect hexagonal grid. The slight skew of the aperture pattern that is proposed is not expected to cause a significant impact or changes in the electro-optical properties of a condenser lens array that comprises the aperture array.

The grid shown in **FIG 12B** is exaggerated to show the difference between the shape of the grid on entry to the plurality of strip arrays 390 in i) compared to the shape of the grid when the sub-beams are exiting the plurality of strips arrays 390 (or the deflector 300, 235) at iii). **FIG 12C** shows that the sub-beams may collide with the electrodes of the strip arrays 390a, 390b and/or 390c when the grid is not distorted as in the present aspect for example up beam of the deflector 300, 235. That the grid has a distortion (or perturbation) applied by the beam limiting aperture array 225 means that the shifts (of the respective beam positions in the grid) due to the beams passing through the plurality of strip arrays 390 are accounted for. Such a prior distortion to the beam grid may help prevent (or at least reduce the incidence of) the collision of beam trajectories with the electrodes 301 of the strip arrays 390, for example as shown in **FIG 12D.**

This solution may be a less trivial modification than it sounds for two reasons. First, one is not free to modify the sub-beam position independently from the sub-beam propagation direction (slope). This is because the sub-beams all originate from the same electron source point. Consequently the sub-beam slope is restricted to be strictly proportional to the sub-beam position angle. So in practice, applying the position shift $\delta x,\ \delta y$ will automatically modify the incident slope $\delta x',\ \delta y'$ on the beam limiting aperture array 225 accordingly. This proportionality is $(\delta x',\ \delta y') = (\delta x,\ \delta y)\ \theta/Np$. However, it may be shown that these unwanted extra contributions to the slope may be compensated by slight modifications of the overall deflection magnitudes of the three slit arrays. Secondly, if one starts with different sub-beam positions, the positions in all three slit arrays changes. This means that the set of slit array pitches and strip array rotations as described in the first aspect may no longer qualify anymore to align the slit array bars to the local sub-beam positions. A different set will be needed to accommodate the sub-beams while avoiding collisions of sub-beams with elongate electrodes 301. This different set can be readily calculated by the same methods as used in the first aspect described above.

In the original baseline configuration without any pitch or rotational adjustment, the strip arrays are oriented at exactly 60 degrees with respect to each other, and the spacing between the slits equals $\sqrt{3p}/4$ . This can be referred to as the standard configuration. It can be shown that the slit positions and orientations are adjusted to the sub-beam trajectory shifts throughout the arrays if:

1. The vertical center of the collimator (i.e. the center of the middle strip array) is positioned at the height in the system where the beam pitch is equal to the design pitch $p$;
2. The pitch of the up-beam strip array 390a is reduced by a factor 1 - $Q/2$ and the up-beam strip array 390a is rotated by an angle $Q/2\sqrt{3}$ compared to the standard configuration;
3. The pitch of the middle strip array 390b is reduced by a factor 1 - $Q/6$ and the middle strip array 390b is rotated by an angle $-Q/2\sqrt{3}$ compared to the standard configuration; and
4. The down-beam slit array 390c is not modified compared to the standard configuration.

Advantages of the third aspect may include reduction of the corrective deflections required from the subsequent multipole deflector array, and/or avoiding non-telecentric electron beam and beam landing position error on the wafer, both of which may affect resolution and contrast.

In an embodiment, a charged particle optical device is provided for projecting a plurality of beams of charged particles towards a sample position. The plurality of beams are arranged in a grid. The device has features comprising: a beam limiting aperture array, a controller and a plurality of strip arrays. In the beam limiting aperture array are defined a plurality of apertures positioned so as to generate the grid of the plurality of beams. The plurality of strip arrays are positioned along the paths of the plurality of beams. The strip arrays comprise electrodes that extend across a path of the plurality of beams desirably so as to operate on the beams that pass between adjoining electrode of the respective strip array to collimate the path of the passing beams. The orientation of the strips in the array of at least two different arrays along the beam path are different. The controller is configured to be connected to and apply a potential difference to the electrodes of the plurality of strips desirably so that the plurality of strips collimate the grid. At least one of the features of the device has an adjusted characteristic configured to mitigate an aberration in the grid. The aberration in the grid is induced by passage of the plurality of beams through the plurality of strip arrays. The controller may be the same as controller 50 described herein. The adjusted characteristic is desirably equal to the aberration, wherein the aberration is the perturbation.

Desirably, the at least one feature comprises the beam limiting aperture array and the perturbed characteristic is the position of the plurality of apertures, desirably the positions of the apertures are arranged in a distorted two dimensional array.

Desirably, the at least one feature comprises the plurality of strip arrays and desirably the perturbed characteristic is aberrations generated in the beam grid by at least one of the strip arrays, desirably at least two of the plurality of strip arrays comprise electrodes that extend in the same orientation in a plane across the direction of the paths of the beams desirably so as to compensate the aberrations that the at least one of the plurality of strip arrays generate in the grid desirably the at least two strip arrays are positioned either side of a plane of intermediate focus along the paths of the beams.

Desirably, the at least one feature comprises the plurality of strip arrays and desirably the perturbed characteristic is positions of the one or more beams in the grid induced by at least one of the strip arrays, wherein the strips of at least one of the plurality of strip arrays is positioned based on shifted locations of the paths of the beams so as to be mitigated for by the perturbation.

Although it is described above that the plurality of beams are generated along divergent beam paths from a diverging beam emitted by a source, this is not a necessity. The same beam limiting aperture array could theoretically be used with a converging plurality of beams, or one in which the beams are substantially collimated.

Although it is described above that the beam limiting aperture array 225 can be part of the array of condenser lenses 231, these components could instead be provided separately. Thus, the beam limiting aperture array 225 may be provided without being in contact with, or part of, the array condenser lenses 231.

It will be understood that there may be variations and components which may be applied to any or all of the aspects of the invention as described above. Some variations and additional components are described below.

Although the plurality of strip arrays are described above as being part of the deflector array 235 (as shown in FIG 3), the plurality of strip arrays 390 (and the deflector 300) may be positioned in any appropriate location. For example, the plurality of strip arrays may be provided in combination with other components, such as described for the deflector array (132) of WO2021078352.

For example only, the plurality of strip arrays could be combined with macro lenses. In this instance, the macro lens would be a magnetic lens such that the strip arrays would not disturb the magnetic fields. The macro lenses could be provided as a combined electrostatic and magnetic lens, and in this case, the strip arrays can be provided downbeam of the macro lenses. Such strip arrays may be used to collimate the sub-beams of a beam grid. The strip arrays may be used to apply a fine deflection to a substantially collimating deflection of the sub-beams of a diverging beam grid by the macro-lens. The collimation may be a combination of the operation of the macro lens and the deflector 300 of the plurality of strip areas as herein disclosed.

It is mentioned above that an array of a multipole deflectors (i.e. a multipole deflector array) which may be referred to as an array of individual beamlet correctors. The multipole deflectors may be used to compensate for types of aberration such as shifts of the sub-beam position in the beam grid and in some circumstances astigmatisms. Such an array of multipole deflectors 400 may be provided in addition to any of the above embodiments of deflector 300, 235. An exemplary position of the multipole deflectors 400 is shown in FIG 3, for example down beam of the deflector array 300 comprising the plurality of slit arrays arranged along the path of the beam grid. However as noted in WO 2021156121 A1 Fig 9, the multipole deflector array may be positioned elsewhere along the path of the beam grid relative to the strip arrays, which description is hereby incorporated by reference so far as the different positions that a multi-beam deflector array may be positioned between, up beam and down beam of strip deflectors 390 of a deflector 300, 235.

For example, the multipole deflector array comprises a substrate or plate in which a plurality of apertures are defined. Each of the multipoles in the array may be applied to one or a group of sub-beams. Desirably the position of the apertures corresponds to the expected beam paths of the beam grid at the position of the multipole deflector array is positioned along the path of the beam grid. Each multipole may be associated with a respective aperture. Each multipole may comprise a plurality of electrodes, desirably the different poles of the multi-pole corresponding to one more of the plurality of electrodes. Desirably the electrodes of each multipole are at a periphery of a respective aperture. Desirably the electrodes are individually controllable desirably via circuitry with the plate, desirably so that the different poles of the multipole can be set, for example dynamically during operation. The array of multipoles may be a CMOS structure, desirably wherein the array of multipoles is configured at least to counter a characteristic of the grid induced by passage of the plurality of beams through the plurality of strip arrays. The array of multipoles may thus be used in combination with any of the embodiments of the invention to further lessen a characteristic of the grid, such as deflection from the desired beam position. Examples of such multipole deflector arrays are disclosed in EP2702595 and EP2715768 each of which are incorporated by reference at least so far as the disclosure of such multipole deflector arrays.

Such a multipole array be used to achieve fine corrections of characteristics such as an aberration of the different sub-beams of the beam grid, such as the position of a beam within the beam grid. Such a multipole array may be used in combination with the different aspects individually or in combination for example as implemented in deflector 235 as depicted in FIG. 3; or as a deflector 300 positioned associated with for example down beam of a macro lens. Such an arrangement having the macro lens, the deflector 300 comprising at least the slit arrays 390 thus additionally may comprise the multipole deflector array 400. Desirably any aberration in the beam grid for example in the position of the sub-beams within the beam grid may be compensated for collimation of the beam grid (i.e. the constituent sub-beams of the beam grid). Thus such a compensated beam grid down beam of the deflector 300 and the multipole deflector array maybe for operation by the objective lens array and incidence on the sample or at a sample position with a beam grid having reduced if minimised aberrations.

In the above embodiments, the plurality of strip arrays 390 are shown in the figures and in some cases described as being equally or evenly spaced from each other along the paths of the plurality of beams. Thus, the strip arrays may be spaced apart from each other with substantially equal intervals between each adjacent strip array. Having evenly spaced strip arrays may be beneficial in that mechanical and electrical design and manufacturing may be easier when each layer and also the support between the layers is identical (or at least substantially the same). Desirably the spacing may be optimized in that the spacing is not too small to prevent electric breakdown from one layer to the next and is not too large to keep the trajectory shifts small and to avoid operating far from focus. Although this is preferred, it is not a necessity. For example, the strip arrays may be unequally-spaced and in this case, the compensation described for example with aspect 2 may still be achieved by appropriate pitch changes and rotations.

The present invention may also provide a method of of projecting beams of charged particles towards a sample position using a beam limiting aperture array 225 and/or a plurality of strip arrays 390 as described in any of the variations or embodiments described above.

A method is provided of projecting beams of charged particles towards a sample position using a beam limiting aperture array and a plurality of strip arrays. The method comprising: a) generating a grid of a plurality of beams from a diverging beam emitted by a source; b) projecting the plurality of beams along beam paths towards the sample position through the plurality of strip arrays; and c) using at least one of the beam limiting aperture array and the plurality of strip arrays, countering a characteristic of the grid induced by passage of the plurality of beams through the plurality of strip arrays.

In the present description, it will be understood that the charged particles/signal particles are generally intended to be electrons, or other negatively charged particles. However, contrary to the above, the charged particles/signal particles may be positively charged particles, e.g. ions. Thus, a primary ion beam may be provided. With a primary ion beam, secondary ions could be emitted from the sample that could be detected by the charge based type detector. However, this would also generate negative charged particles, e.g. secondary electrons at the same time. So the charge accumulated with this charge based type detector will be a mix of positively and negatively charged particles, which would make the charged measurement unreliable. However, having either a positive or negative bias on the charge based type detector would make it possible to choose one of the charge polarities. Because of the much smaller range of ions than electrons in a material, backscatter ions need a much larger kinetic energy to be able to reach any further detectors, e.g. the scintillator and/or semiconductor type detector. Thus, not all backscatter ions will make it to this detector component. To improve the detection of backscatter ions, the charge based type detector could be made thinner. In the instance that ions are used instead of negatively charged particles, then any bias referred to above would be opposite, e.g. a positive bias should be used instead of a negative one and vice versa.

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector. References to elements being aligned along a beam path or sub-beam path are understood to mean that the respective elements are positioned along the beam path or sub-beam path. References to optics are understood to mean electron-optics.

While the description and drawings are directed to an charged particle optical device, it is appreciated that the embodiments are not used to limit the present disclosure to specific charged particles. The charged particles referenced throughout the present document may be electrons. However, references to electrons throughout the present document may therefore be more generally be considered to be references to charged particles, with the charged particles not necessarily being electrons. The charged-particle optical device may be a negative charged particle device. The charged-particle optical device may otherwise be referred to as an electron-optical device. It will be understood that an electron is a specific charged particle and can replace all instances of charged particle referred to throughout the application as appropriate. For example, the source may specifically provide electrons. The charged particle referred to throughout the specification may be specifically a negatively charged particle.

The charged particle optical device may more specifically be defined as a charged particle optical column. In other words, the device may be provided as a column, and device and column could be used interchangeably in the description above. The column may thus comprise an objective lens array assembly as described above. The column may thus comprise a charged particle optical system as described above, for example comprising an objective lens array and optionally a detector array and/or optionally a condenser lens array.

The charged particle optical device described above comprises at least the objective lens array 240. The charged particle optical device may comprise the detector array 241 and/or detector assembly. The charged particle optical device may comprise the control lens array 250. The charged particle optical device comprising the objective lens array and the detector array may thus be interchangeable with, and referred to as, the objective lens array assembly, which may optionally comprise the control lens array 250. The charged particle optical device may comprise additional components, e.g. as described in relation to FIG. 3. Thus, the charged particle optical device 41 may be interchangeable with, and referred to as, a charged particle beam apparatus 40 and/or an charged particle beam assessment system 100 if comprising the additional components in these figures.

References to up and low, upper and lower, lowest, up and down, above and below should be understood as referring to directions parallel to the (typically but not always vertical) up-beam and down-beam directions of the electron beam or multi-beam impinging on the sample 208. Thus, references to up beam and down beam are intended to refer to directions in respect of the beam path independently of any present gravitational field.

References to elements being aligned along a beam path or sub-beam path are understood to mean that the respective elements are positioned along the beam path or sub-beam path.

An assessment system 100 according to an embodiment of the invention may be a tool which makes a qualitative assessment of a sample (e.g. pass/fail), one which makes a quantitative measurement (e.g. the size of a feature) of a sample or one which generates an image of map of a sample. Thus, the assessment system 100 could be any appropriate device, apparatus or system used for assessment. For example, the assessment system 100 could be any of the charged particle beam apparatus 40, or more specifically the charged particle optical device 41, and/or as part of an optical lens array assembly, when used for assessment. Examples of assessment tools are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). The charged particle beam device 40 (which may be a charged particle -optical column) may be a component of an assessment tool; such as an inspection tool or a metro-inspection tool, or part of an e-beam lithography tool. Any reference to a tool herein is intended to encompass a device, apparatus or system, the tool comprising various components which may or may not be collocated, and which may even be located in separate rooms, especially for example for data processing elements.

Reference to a component or system of components or elements being controllable to manipulate a charged particle beam in a certain manner includes configuring a controller or control system or control unit to control the component to manipulate the charged particle beam in the manner described, as well as optionally using other controllers or devices (e.g. voltage supplies and/or current supplies) to control the component to manipulate the charged particle beam in this manner. For example, a voltage supply may be electrically connected to one or more components to apply potentials to the components, such as in a non-limited list including the control lens array 250, the objective lens array 241, the condenser lens 231, correctors, collimator element array 271 and scan deflector array 260, under the control of the controller or control system or control unit. An actuatable component, such as a stage, may be controllable to actuate and thus move relative to another components such as the beam path using one or more controllers, control systems, or control units to control the actuation of the component.

The embodiments herein described comprising a detector assembly may take the form of a series of aperture arrays or charged particle optical elements arranged in arrays along a beam or a multi-beam path. Such charged particle optical elements may be electrostatic. In an embodiment all the charged particle optical elements, for example from a beam limiting aperture array to a last charged particle optical element in a sub-beam path before a sample, may be electrostatic and/or may be in the form of an aperture array or a plate array. In some arrangements one or more of the charged particle optical elements are manufactured as a microelectromechanical system (MEMS) (i.e. using MEMS manufacturing techniques).

The system or device of such architectures as depicted in at least **FIG.** 3 and as described above may comprise components such as an up-beam beam limiter, a collimator element array 271, a control lens array 250, a scan deflector array 260, an objective lens array 241, a beam shaping limiter and/or a detector array 241 and/or detector assembly; one or more of these elements that are present may be connected to one more adjacent elements with an isolating element such as a ceramic or glass spacer.

Any element or collection of elements may be replaceable or field replaceable within the charged particle beam tool, for example with the charged particle device 40. The one or more charged particle optical components in the charged particle beam tool for example with the charged particle device 40, especially those that operate on sub-beams or generate sub-beams, such as aperture arrays and manipulator arrays may comprise one or more MEMS.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

There is provided the following clauses:

Clause 1. A charged particle optical device for projecting a plurality of beams of charged particles towards a sample position, the plurality of beams arranged in a grid, the device comprising: a beam limiting aperture array in which are defined a plurality of apertures positioned so as to generate the grid of the plurality of beams; a plurality of strip arrays positioned along the paths of the plurality of beams, the strip arrays extending across a path of the plurality of beams so as to operate on the charged particles that pass along the path between strips of the respective strip array to collimate the path of the passing beams, and the orientation of the strips in the array of at least two different arrays along the beam path being different, wherein the at least one of the beam limiting aperture array and the plurality of strip arrays is configured to mitigate a characteristic of the grid that is induced by passage of the plurality of beams through the plurality of strip arrays.

Clause 2. The charged particle optical device of clause 1, wherein the characteristic of the grid induced by propagation of the plurality of beams through the plurality of strip arrays is the difference between the actual position of each of the beams in the grid and the desired position of that beam in the grid.

Clause 3. The charged particle optical device of either of clauses 1 or 2, wherein the plurality of strips arrays are configured to counter the characteristic of the grid.

Clause 4. The charged particle optical device of any one of the preceding clauses, wherein the strips of at least one of the plurality of strip arrays is positioned based on shifted locations of the paths of the beams.

Clause 5. The charged particle optical device of any one of the preceding clauses, wherein a pitch of a slit for the passage therethrough of the beams defined in at least one of the strip arrays is smaller than a pitch of a slit for the passage therethrough of the beams defined in another one of the strip arrays further down-beam., desirably a slit is defined between the facing surfaces of adjacent strips in a strip array.

Clause 6. The charged particle optical device of any one of the preceding clauses, wherein the plurality of strip arrays comprises at least an up-beam strip array, a middle strip array and a down-beam strip array, wherein the strip arrays each define slits for the passage therethrough of the plurality of beams, desirably the slit are defined between facing surfaces of adjacent strips in a strip array.

Clause 7. The charged particle optical device of clause 6, wherein a pitch of the slits as defined by the up-beam strip array is smaller than a pitch of the slits defined by the middle strip array and/or the pitch of the slits defined by the down-beam strip array.

Clause 8. The charged particle optical device of either one of clauses 6 or 7, wherein a pitch of the slits defined by the middle strip array is smaller than a pitch of the slits defined by the down-beam strip array.

Clause 9. The charged particle optical device of any of clauses 6 to 8, the strips in a strip array having a common orientation across the paths of the plurality of beams, the common orientation of the plurality of strip arrays having a rotational symmetry with a geometric angular displacement between the orientations of the strip arrays, desirably wherein the angular displacement between at least two of arrays is perturbed to have an angular displacement different from the geometric angular displacement, desirably greater than the geometric angular displacement, desirably the geometric angular displacement is substantially 60, 90 or 120 degrees.

Clause 10. The charged particle optical device of any one of clauses 6-9, desirably the strips in a strip array having a common orientation across the paths of the plurality of beams, wherein the angle between the orientation of the up-beam strip array and the orientation of the middle strip array is other than, desirably greater than, substantially 60 degrees.

Clause 11. The charged particle optical device of any one of clauses 6-10, desirably the strips in a strip array having a common orientation across the paths of the plurality of beams, wherein the angle between the orientation of the middle strip array and the orientation of the down-beam strip array is other than, desirably greater than, substantially 60 degrees

Clause 12. The charged particle optical device of any one of the preceding clauses, wherein at least of two of the strip arrays extend in the same orientation in a plane across the direction of the paths of the beams and desirably the at least two strip arrays are configured to deflect the plurality of beams so that the net deflection on the beams is distributed between each of the at least two strip arrays and desirably the displacement of the beams by each of the at least two strip arrays compensate each other.

Clause 13. The charged particle device of clause 12, wherein all the strip arrays extend in the same orientation as another of the strip arrays, desirably to be similarly orientated strip arrays.

Clause 14. The charged particle optical device of any one of the preceding clauses, wherein at least two of the plurality of strip arrays are provided in pairs, with each pair comprising two strip arrays extending in the same orientation in the plane, each pair being similarly orientated strip arrays.

Clause 15. The charged particle optical device of clause 13 or 14, wherein similarly orientated arrays have an up-beam strip array and a down-beam strip array along the beam path, wherein all the up-beam strip arrays are positioned up-beam of the corresponding down-beam strip arrays and/or the up-beam strip arrays are positioned up-beam of an intermediate focus plane of the plurality of beams and/or the down-beam strip arrays are positioned down-beam of an intermediate focus plane of the plurality of beams.

Clause 16. The charged particle optical device of clause 15, wherein the up-beam strip arrays are provided in a first order and the down-beam strip arrays are provided in a second order, wherein the second order is a reverse of the first order.

Clause 17. The charged particle optical device of any one of clauses 11 to 16, wherein the plurality of strip arrays comprises at least six strip arrays.

Clause 18. The charged particle optical device of any one of the preceding clauses, wherein the beam limiting aperture array is configured to at least partly counter the characteristic of the grid.

Clause 19. The charged particle optical device of clause 18, wherein the beam limiting aperture is positioned up-beam of the plurality of strip arrays.

Clause 20. The charged particle optical device of clause 19, wherein the beam limiting aperture array is configured to provide the plurality of beams in the grid in a distorted arrangement, desirably the characteristic of the grid is a distortion in the symmetry of a pattern of the grid desirably for which the distorted pattern is configured to compensate.

Clause 21. The charged particle optical device of any one of clauses 18-20, wherein in the beam limiting aperture array are defined apertures positioned so as to generate the grid of the plurality of beams desirably along divergent beam paths from a diverging beam emitted by a source.

Clause 22. The charged particle optical device of any one of clauses 18-21, wherein the beam limiting aperture array is comprised in a condenser lens array, desirably wherein the condenser lens array is configured to focus the beams at respective intermediate foci.

Clause 23. The charged particle device of any one of clauses 20 to 22, wherein apertures defined in the beam limiting aperture array have the distorted arrangement in which the apertures are arranged in at least two lines having different orientations, wherein the at least two lines having an aperture pitch that differs, desirably the aperture pitch of at least two lines are similar, and/or the differing orientations are mutually rotationally asymmetrical about an origin of the beam grid desirably at least two of the orientations being rotationally symmetrical about the origin.

Clause 24. The charged particle optical device of any one of the preceding clauses, wherein the grid has a threefold symmetry, desirably wherein the grid is a substantially hexagonal.

Clause 25. The charged particle optical device of any one of the preceding clauses, further comprising a multipole deflector array comprising an array of multipoles, desirably the multipole deflector array comprises a plate in which is defined a plurality of apertures, desirably each multipole is associated with a respective aperture, desirably each multiple comprises a plurality of electrodes, desirably the electrodes of each multipole are at a periphery of the respective aperture, desirably the electrodes are individually controllable desirably via circuitry with the plate, desirably the array of multipoles is a CMOS structure, desirably wherein the array of multipoles is configured at least to counter a characteristic of the grid induced by passage of the plurality of beams through the plurality of strip arrays.

Clause 26. The charged particle optical device of any one of the preceding clauses, wherein the strip arrays are evenly spaced from each other along the paths of the plurality of beams.

Clause 27. A method of projecting beams of charged particles towards a sample position using a beam limiting aperture array and a plurality of strip arrays, the method comprising: a) generating a grid of a plurality of beams from a diverging beam emitted by a source; b) projecting the plurality of beams along beam paths towards the sample position through the plurality of strip arrays; and c) using at least one of the beam limiting aperture array and the plurality of strip arrays, countering a characteristic of the grid induced by passage of the plurality of beams through the plurality of strip arrays.

Clause 28. A charged particle optical device for projecting a plurality of beams of charged particles towards a sample position, the plurality of beams arranged in a grid, the device having features comprising: a beam limiting aperture array in which are defined a plurality of apertures positioned so as to generate the grid of the plurality of beams; a plurality of strip arrays positioned along the paths of the plurality of beams, the strip arrays comprising electrodes extending across a path of the plurality of beams so as to operate on the beams that pass between adjoining electrode of the respective strip array to collimate the path of the passing beams, and the orientation of the strips in the array of at least two different arrays along the beam path being different; and a controller configured to be connected to and apply a potential difference to the electrodes of the plurality of strips so that the plurality of strips collimate the grid, wherein at least one of the features of the device has an adjusted characteristic configured to mitigate an aberration in the grid that is induced by passage of the plurality of beams through the plurality of strip arrays.

Clause 29. The charged particle optical device of clause 28, wherein the at least one feature comprises the beam limiting aperture array and the perturbed characteristic is the position of the plurality of apertures, desirably the positions of the apertures are arranged in a distorted two dimensional array.

Clause 30. The charged particle optical device of clause 28 or 29, wherein the at least one feature comprises the plurality of strip arrays and desirably the perturbed characteristic is aberrations generated in the beam grid by at least one of the strip arrays, desirably at least two of the plurality of strip arrays comprise electrodes that extend in the same orientation in a plane across the direction of the paths of the beams desirably so as to compensate the aberrations that the at least one of the plurality of strip arrays generate in the grid desirably the at least two strip arrays are positioned either side of a plane of intermediate focus along the paths of the beams.

Clause 31. The charged particle optical device of any of clauses 28 to 30, wherein the at least one feature comprises the plurality of strip arrays and desirably the perturbed characteristic is positions of the one or more beams in the grid induced by at least one of the strip arrays, wherein the strips of at least one of the plurality of strip arrays is positioned based on shifted locations of the paths of the beams so as to be mitigated for by the perturbation.

## Claims

1. A charged particle optical device for projecting a plurality of beams of charged particles towards a sample position, the plurality of beams arranged in a grid, the device comprising:

a beam limiting aperture array in which are defined a plurality of apertures positioned so as to generate the grid of the plurality of beams;

a plurality of strip arrays positioned along the paths of the plurality of beams, the strip arrays extending across a path of the plurality of beams so as to operate on the charged particles that pass along the path between strips of the respective strip array to collimate the path of the passing beams, and the orientation of the strips in the array of at least two different arrays along the beam path being different,

wherein the at least one of the beam limiting aperture array and the plurality of strip arrays is configured to mitigate a characteristic of the grid that is induced by passage of the plurality of beams through the plurality of strip arrays.

2. The charged particle optical device of claim 1, wherein the characteristic of the grid induced by propagation of the plurality of beams through the plurality of strip arrays is the difference between the actual position of each of the beams in the grid and the desired position of that beam in the grid.

3. The charged particle optical device of either of claims 1 or 2, wherein the plurality of strips arrays are configured to counter the characteristic of the grid.

4. The charged particle optical device of any of the preceding claims, wherein the strips of at least one of the plurality of strip arrays is positioned based on shifted locations of the paths of the beams.

5. The charged particle optical device of any of the preceding claims, wherein a pitch of a slit for the passage therethrough of the beams defined in at least one of the strip arrays is smaller than a pitch of a slit for the passage therethrough of the beams defined in another one of the strip arrays further down-beam.

6. The charged particle optical device of any of the preceding claims, wherein the plurality of strip arrays comprises at least an up-beam strip array, a middle strip array and a down-beam strip array, wherein the strip arrays each define slits for the passage therethrough of the plurality of beams.

7. The charged particle optical device of claim 6, wherein a pitch of the slits as defined by the up-beam strip array is smaller than a pitch of the slits defined by the middle strip array and/or the pitch of the slits defined by the down-beam strip array.

8. The charged particle optical device of either of claims 6 or 7, wherein a pitch of the slits defined by the middle strip array is smaller than a pitch of the slits defined by the down-beam strip array.

9. The charged particle optical device of any of claims 6 to 8, the strips in a strip array having a common orientation across the paths of the plurality of beams, the common orientation of the plurality of strip arrays having a rotational symmetry with a geometric angular displacement between the orientations of the strip arrays.

10. The charged particle optical device of any of claims 6-9, wherein the angle between the orientation of the up-beam strip array and the orientation of the middle strip array is other than substantially 60 degrees.

11. The charged particle optical device of any of the preceding claims, wherein at least of two of the strip arrays extend in the same orientation in a plane across the direction of the paths of the beams r.

12. The charged particle optical device of any one of the preceding claims, wherein at least two of the plurality of strip arrays are provided in pairs, with each pair comprising two strip arrays extending in the same orientation in the plane, each pair being similarly orientated strip arrays.

13. The charged particle optical device of any of the preceding claims, wherein the beam limiting aperture array is configured to counter the characteristic of the grid.

14. The charged particle optical device of any of the preceding claims, wherein the grid has a threefold symmetry.

15. The charged particle optical device of any of the preceding claims, further comprising a multipole deflector array comprising an array of multipoles.

# Fig. 1

# Fig. 2

# Fig. 3

## Fig. 4

## Fig. 5

## Fig. 6

## Fig. 7

Fig. 8

Fig. 9A

Fig. 9B  Fig. 9C  Fig. 9D

i)  301a

ii)  301b

iii)  301c

390a

390b

390c

EP 4 280 252 A1

Fig. 10A

i)
301a

ii)
301b

iii)
301c

iv)
301d

v)
301e

vi)
301f

391

Fig. 10B

391

Fig. 10C

391

Fig. 10D

390a

390b

390c

391

390d

390e

390f

## Fig. 11A

## Fig. 11B

Fig. 12A

Fig. 12B    Fig. 12C    Fig. 12D

Europäisches
Patentamt

European
Patent Office

Office européen
des brevets

# EUROPEAN SEARCH REPORT

Application Number

EP 22 17 3531

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | WO 2021/156121 A1 (ASML NETHERLANDS BV [NL]) 12 August 2021 (2021-08-12) * paragraphs [0064], [0077], [0096] – [0101], [0106], [0115] – [0123]; figures * | 1-15 | INV.<br>H01J37/147<br>H01J37/153 |
| X | WO 2021/204734 A1 (ASML NETHERLANDS BV [NL]) 14 October 2021 (2021-10-14) * paragraphs [0059], [0076] – [0086]; figures * | 1-15 | |
| X | WO 2021/078352 A1 (APPLIED MATERIALS ISRAEL LTD [IL]; UNIV DELFT TECH [NL]) 29 April 2021 (2021-04-29) * paragraphs [0058] – [0081]; figures 1,7A,7B,7C,8A, 8B,9,10,11 * | 1-4,6, 9-13,15 | |

TECHNICAL FIELDS
SEARCHED        (IPC)

H01J

The present search report has been drawn up for all claims

| Place of search | Date of completion of the search | Examiner |
|---|---|---|
| Munich | 28 October 2022 | Schmidt-Kärst, S |

EPO FORM 1503 03.82 (P04C01)

## ANNEX TO THE EUROPEAN SEARCH REPORT
## ON EUROPEAN PATENT APPLICATION NO.

EP 22 17 3531

This annex lists the patent family members relating to the patent documents cited in the above-mentioned European search report.
The members are as contained in the European Patent Office EDP file on
The European Patent Office is in no way liable for these particulars which are merely given for the purpose of information.

28-10-2022

| Patent document cited in search report | | Publication date | Patent family member(s) | | Publication date |
|---|---|---|---|---|---|
| WO 2021156121 | A1 | 12-08-2021 | CA | 3167120 A1 | 12-08-2021 |
| | | | CN | 115053319 A | 13-09-2022 |
| | | | EP | 3863040 A1 | 11-08-2021 |
| | | | KR | 20220123701 A | 08-09-2022 |
| | | | TW | 202143283 A | 16-11-2021 |
| | | | WO | 2021156121 A1 | 12-08-2021 |
| WO 2021204734 | A1 | 14-10-2021 | EP | 3893264 A1 | 13-10-2021 |
| | | | TW | 202204886 A | 01-02-2022 |
| | | | WO | 2021204734 A1 | 14-10-2021 |
| WO 2021078352 | A1 | 29-04-2021 | CN | 114830286 A | 29-07-2022 |
| | | | EP | 4049301 A1 | 31-08-2022 |
| | | | KR | 20220083798 A | 20-06-2022 |
| | | | TW | 202117784 A | 01-05-2021 |
| | | | WO | 2021078352 A1 | 29-04-2021 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 20184161
- US 20210319977 A
- US 2020118784 A
- US 20200203116 A
- US 20190259570 A
- US 20190259564 A
- EP 1602121 A1
- EP 20207178
- EP 21174518
- EP 2702595 A1
- EP 2715768 A2
- US 20100276606 A
- EP 2021077305 W
- EP 3020062 A1
- WO 2021078352 A
- WO 2021156121 A1
- EP 2702595 A
- EP 2715768 A